(19) Europäisches Patentamt / European Patent Office / Office européen des brevets

(11) **EP 2 415 225 B1**

(12) **FASCICULE DE BREVET EUROPEEN**

(45) Date de publication et mention
de la délivrance du brevet:
**18.12.2013 Bulletin 2013/51**

(21) Numéro de dépôt: **10717677.8**

(22) Date de dépôt: **30.03.2010**

(51) Int Cl.:
*H04L 27/26* *(2006.01)*    *H04L 1/00* *(2006.01)*
*H04L 5/00* *(2006.01)*    *H03M 13/27* *(2006.01)*

(86) Numéro de dépôt international:
**PCT/FR2010/050584**

(87) Numéro de publication internationale:
**WO 2010/112754 (07.10.2010 Gazette 2010/40)**

(54) **PROCEDE ET DISPOSITIF D'EMISSION AVEC MAPPAGE TEMPS-FREQUENCE DES SYMBOLES DANS DES SOUS-CANAUX**

ÜBERTRAGUNGSVERFAHREN UND EINRICHTUNG MIT SYMBOL-ZEIT-FREQUENZ-ABBILDUNG IN SUBKANÄLEN

TRANSMISSION METHOD AND DEVICE WITH SYMBOL TIME-FREQUENCY MAPPING IN SUB-CHANNELS

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **31.03.2009 FR 0952074**

(43) Date de publication de la demande:
**08.02.2012 Bulletin 2012/06**

(73) Titulaire: **Orange**
**75015 Paris (FR)**

(72) Inventeur: **SIAUD, Isabelle**
**F-35000 Rennes (FR)**

(56) Documents cités:
**WO-A2-2008/087351    FR-A1- 2 880 483**
**US-A1- 2005 265 469    US-A1- 2009 022 237**

**Description**

La présente invention se rapporte au domaine des télécommunications. Au sein de ce domaine, l'invention se rapporte plus particulièrement aux communications dites numériques. Les communications numériques comprennent en particulier les communications sans fil ; elles comprennent aussi par exemple les communications filaires. Le support de transmission des communications est couramment appelé canal de transmission ou de propagation, à l'origine en référence à un canal aérien et par extension en référence à tout canal.

L'invention concerne les techniques de mappage de symboles dans des sous canaux répartis sur un ou plusieurs symboles multi porteuses, typiquement OFDM (en anglais "Orthogonal Frequency Division Multiplexing"). Ces techniques sont généralement mises en oeuvre avec une technique d'accès multi utilisateurs, par exemple de type OFDMA (en anglais "Orthogonal Frequency Division Multiple Access").

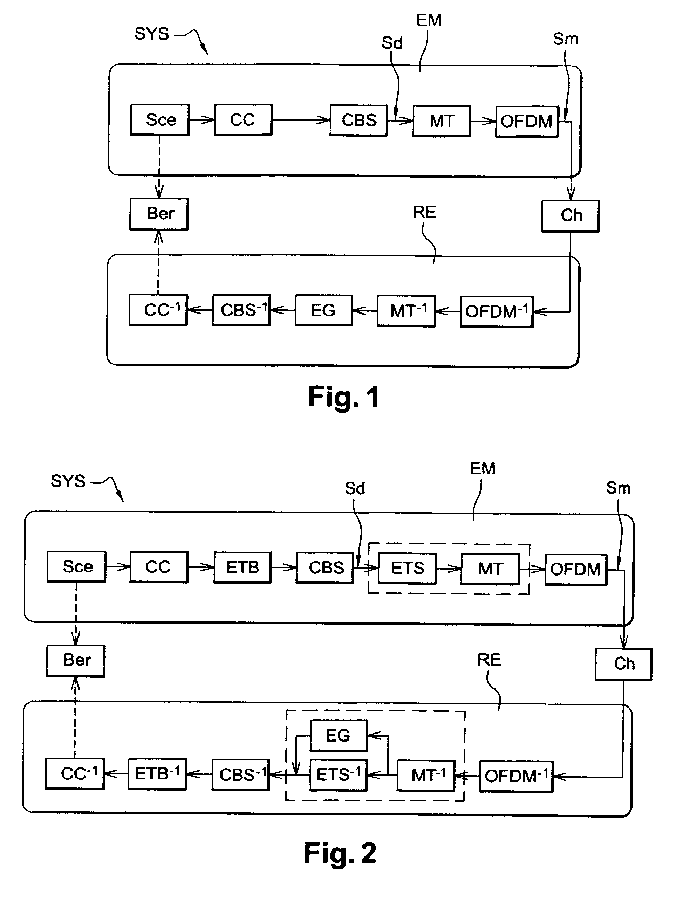

L'invention s'applique en particulier à tout type de système de transmission à porteuses multiples. La figure 1 représente une chaîne d'émission/réception classique décrite en bande de base pour un tel système SYS qui comprend un émetteur EM et un récepteur RE. Le signal de sortie de l'émetteur est transmis par un canal de propagation Ch au récepteur RE. La chaîne d'émission comprend un codeur correcteur d'erreur CC, un codeur binaire à symbole CBS, un module de mappage MT, un modulateur OFDM. De manière classique, la chaîne d'émission comprend en outre un module d'insertion d'un intervalle de garde, non représenté, en sortie du modulateur OFDM. La chaîne de réception comprend un démodulateur OFDM OFDM$^{-1}$ (précédé classiquement d'un module de suppression de l'intervalle de garde), un module de de-mappage MT$^{-1}$ un module d'égalisation EG, un décodeur binaire à symbole CBS$^{-1}$, un décodeur correcteur d'erreur CC$^{-1}$.

L'information issue d'une source Sce est codée selon une technique dite de codage correcteur d'erreurs au moyen du codeur CC (les données codées sont éventuellement poinçonnées pour augmenter le débit). Les données sont ensuite mises sous la forme de symboles de données Sd (cellules QAM, QPSK, ...) par le modulateur CBS, dit de Codage Binaire à Symbole. Le module de mappage mappe les symboles de données en entrée du modulateur OFDM qui génère des symboles OFDM Sm. Le mappage des symboles peut être décomposé en une segmentation des symboles de données dans des sous canaux et en une répartition temps et/ou fréquence des sous canaux sur un ou plusieurs symboles OFDM. Le module de mappage peut en outre insérer des symboles pilotes dans chaque sous-canal ou certains sous canaux pour effectuer une égalisation OFDM à la réception à partir des pilotes reçus. L'insertion de symboles pilotes peut être complétée par l'insertion d'un préambule OFDM. Le modulateur OFDM génère des symboles OFDM au moyen d'une transformée de Fourier inverse.

Un modulateur OFDM comporte un réseau de sous porteuses qui correspondent à une subdivision fréquentielle de la bande instantanée du système de transmission. Le modulateur OFDM  effectue la modulation des symboles (données, pilotes, symboles nuls désignés par porteuses de garde) par les sous porteuses qui correspondent aux composantes de Fourier conjuguées d'une transformation de Fourier dont la taille $N_{FFT}$ correspond au nombre de sous porteuses du modulateur OFDM.

Le canal de transmission Ch désigné aussi par canal multi trajet est représenté par la réponse impulsionnelle $h(t,\tau)$ d'un filtre numérique où t représente la variable temps et $\tau$ la variable des retards associée aux coefficients du filtre à l'instant t. Le canal de transmission filtre le signal multi porteuse en pondérant chaque symbole assigné à la porteuse k par la composante correspondante de la fonction de transfert du canal décomposée sur le multiplex OFDM formé de $N_{FFT}$ composantes. Il génère en réception une corrélation des sous porteuses dans les domaines fréquentiel et temporel. La corrélation fréquentielle affecte les sous porteuses et la corrélation temporelle induit des sous porteuses d'amplitude quasi constante sur une fenêtre d'observation de l'ordre du temps de cohérence du canal. Le temps de cohérence correspond à la valeur moyenne de l'écart temporel nécessaire pour assurer une décorrélation du signal représentatif du support de transmission avec sa version décalée temporellement.

Cette double corrélation limite les performances des circuits de décision en réception. La corrélation temporelle induit des paquets d'erreurs après décision des symboles de données transmis et après décodage des bits transmis estimés. Ces effets se rencontrent lorsque l'environnement varie lentement et est multi trajet. C'est en particulier le cas pour les systèmes ultra large bande (Ultra Wide Band ) défini par le Standard ECMA-368, "High Rate Ultra Wideband PHY and MAC Standard", 3st Edition - December 2008, pour les systèmes radio dédiés à la boucle locale radio (Wimax défini par le standard IEEE 802.16e. Air interface for fixed and mobile broadband wireless access systems. IEEE P802.16e/D12 Draft, Oct 2005, DECT ("Digital Enhanced Cordless Telecommunications") défini par le standard ETSI EN 300 175-3 Digital Enhanced Cordless Telecommunications (DECT); Common Interface (CI); Part 3: Medium Access Control (MAC) layer) ou pour les transmissions de type xDSL.

La corrélation fréquentielle résulte à la fois de l'effet multi trajet qui introduit un filtrage, de l'effet Doppler et du bruit de phase des étages RF qui induisent une perte d'orthogonalité des sous porteuses d'un multiplex orthogonal. C'est en particulier le cas des systèmes à courte portée dits Ultra Large Bande et des systèmes définis en bande millimétrique tels qu'étudiés dans l'organisme de normalisation américain IEEE802.15.3c ainsi que des systèmes 4G radio (LTE advanced, Wi-Max) à forte mobilité ou des systèmes très longue distance dédiés aux liaisons radio ionosphériques (système DRM ("Digitale Radio Mondiale") norme ETSI TS 101 980).

Une méthode connue, illustrée par la figure 2. pour remédier à cette double corrélation consiste à mettre en oeuvre à l'émission un entrelacement ETB effectué sur les données binaires et/ou un entrelacement ETS effectué sur les symboles de données Sd.

Les techniques d'entrelacement dans un système de transmission sont donc appliquées sur les données pour décorréler les données reçues et améliorer les circuits de décision.

L'entrelacement est dit binaire quand il porte sur des bits codés ou bien sur des bits directement extraits de la source, bits désignés par le terme anglosaxon scrambling.

L'entrelacement est dit entrelacement de symboles ou procédé d'allocation de symboles par porteuses quand il porte sur les symboles complexes (QPSK, x-QAM....) affectés aux sous porteuses d'un modulateur multi porteuse. Sa taille est généralement égale au nombre $N_{SD}$ de symboles de données par modulateur multi porteuse ou est multiple de $N_{SD}$. Ce type d'entrelacement intervient en amont du modulateur multi porteuse. De manière équivalente, on parle couramment d'entrelacement de porteuses ou de sous porteuses.

Le mappage des symboles en entrée du modulateur OFDM peut être mis en oeuvre différemment en fonction du système.

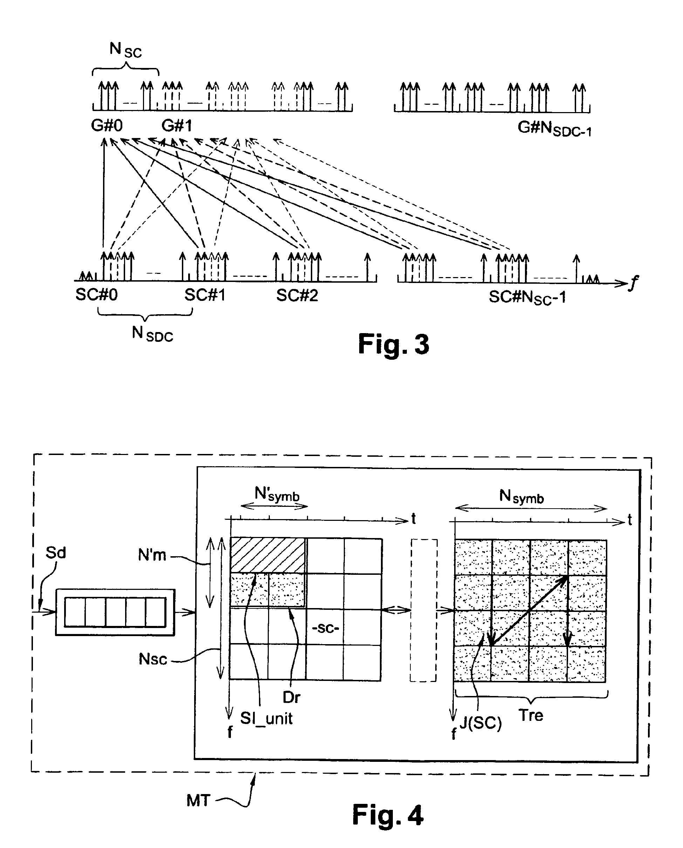

De manière générale, un système OFDM peut être associé à une technique d'accès. En particulier, un procédé OFDMA (Orthogonal Frequency Division Multiple Access) consiste à assigner à des porteuses d'un même symbole OFDM des symboles de données associés à différents utilisateurs ou différents groupes de symboles de données. Dans ce cas, le mappage des symboles de données d'un ou plusieurs utilisateurs consiste à les regrouper dans des sous canaux de taille élémentaire $N_{SDC}$ puis à distribuer ces sous canaux en temps et en fréquence de façon à mixer différents utilisateurs au sein d'un même symbole OFDM. Une illustration en est donnée sur la figure 3 où les sous canaux sont construits en assignant un symbole de chaque groupe à chaque sous canal. Le nombre de sous canaux ainsi construits correspond au nombre de symboles par groupe, $N_{SC}$. et la taille d'un sous canal correspond au nombre de groupes considéré, $N_{SDC}$. Le nombre de sous canaux par symbole OFDM dépend du nombre $N_{SD}$ de symboles de données par symbole OFDM et de la taille $N_{SDC}$ d'un sous canal.

La mise en oeuvre d'un système de l'art antérieur illustrée par les figures 4, 5, 6, 7 se rapportent à un système conforme au standard IEEE 802.16e. Les spécifications considérées du standard ont pour références "Air interface for fixed and mobile broadband wireless access systems and Corrigendum 1". IEEE P802.16e/IEEE Std 802.16e-2005-Approved 7 December 2005, IEEE Std 802.16-2004/Cor 1-2005-Approved 8 November 2005. Un système conforme à ce standard est couramment désigné par les termes système Wimax. Le terme Wimax couvre également le standard Hyperman.

Le standard IEEE802.16e définit une unité élémentaire désignée par OFDMA slot SI_unit qui est constituée par un ou plusieurs sous canaux distribués en temps sur un ou plusieurs symboles OFDMA consécutifs. L'unité en fréquence correspond à la taille d'un sous canal $N_{SDC}$. Cette unité élémentaire OFDMA slot est l'unité élémentaire minimale de transmission correspondant à un mode de modulation et de codage donné (MCS), pour les symboles de données correspondants, qui dépend du mode de transmission (voie descendante, voie montante, mode FUSC (Full Usage of the Subchannels : tous les sous canaux sont alloués à l'émetteur, les pilotes puis les sous canaux de données sont insérés dans la trame OFDMA), mode PUSC (Partial Usage of the Sub-Channels : le nombre de sous canaux alloués peut varier, les pilotes sont soit insérés dans les sous canaux, soit mappés après le mappage des données dans des sous canaux). L'OFDMA slot est un motif élémentaire de répartition des données, et des pilotes éventuellement (mode PUSC liaison montante uniquement où les pilotes sont intégrés à des positions fixes dans l'OFDMA slot), pour un mode de transmission donné. Les OFDMA slots correspondant au même mode de modulation et de codage des symboles (MCS) sont distribués dans le domaine temps-fréquence pour former un bloc Dr (Data Region). Un bloc Dr correspond donc à une unité de transmission à deux dimensions comportant plusieurs OFDMA slots utilisant le même mode de codage-modulation MCS (Modulation and Coding Scheme). Une trame élémentaire OFDMA (Tre) constituée de Nsymb symboles OFDMA (un ou plusieurs) est formée en répartissant en fréquence puis en temps des blocs Dr différents par ordre d'indice croissant afin de former des symboles OFDM complets. Les blocs Dr formant un symbole OFDMA peuvent correspondre à différents modes de transmission (FUSC et PUSC), soit en lien descendant soit en lien montant. La trame globale est partagée en deux parties distinctes, pour la voie descendante et la voie montante. Une trame élémentaire OFDMA est typiquement précédée d'un symbole préambule pour la synchronisation ou l'estimation du canal de propagation à la réception.

L'allocation des pilotes sur le multiplex OFDM peut précéder la distribution des sous-canaux J(sc), ce qui est le cas de la voie descendante du standard IEEE 802.16e, ou elle peut être intégrée dans ceux-ci suivant un motif périodique vis-à-vis de l'OFDMA-slot, ce qui est le cas du mode PUSC du standard IEEE802.16e.

En référence à la figure 4, les symboles de donnés Sd, issus d'un module de codage binaire à symbole CBS ou d'un entrelaceur ETS, sont segmentés dans des sous canaux de taille élémentaire $N_{SDC}$, qui sont répartis en temps et en fréquence dans un OFDMA-slot (SL_unit) par le module de mappage MT. Un OFDMA slot est formé de plusieurs sous canaux répartis en temps sur Nsymb0 symboles OFDM consécutifs suivant l'échelle des temps et un sous-canal de taille $N_{SDC}$ suivant l'échelle des fréquences. Les OFDMA-slots associés au même mode de codage-modulation MCS sont regroupés par le module de mappage MT dans un bloc Dr (Data Region) formé par N'm sous-canaux suivant l'échelle des fréquences et N'symb symboles OFDM suivant l'axe temporel. N'symb est multiple de Nsymb0. N blocs Dr sont successivement répartis en fréquence puis en temps pour constituer une trame élémentaire OFDM Tre à l'aide du module de mappage MT. Une trame élémentaire OFDM Tre est formée par Nsymb symboles OFDM correspondant à N blocs Dr. N'm est sous multiple du nombre de sous-canaux Nsc par symbole OFDM et N'symb dépend du mode de transmission du système considéré.

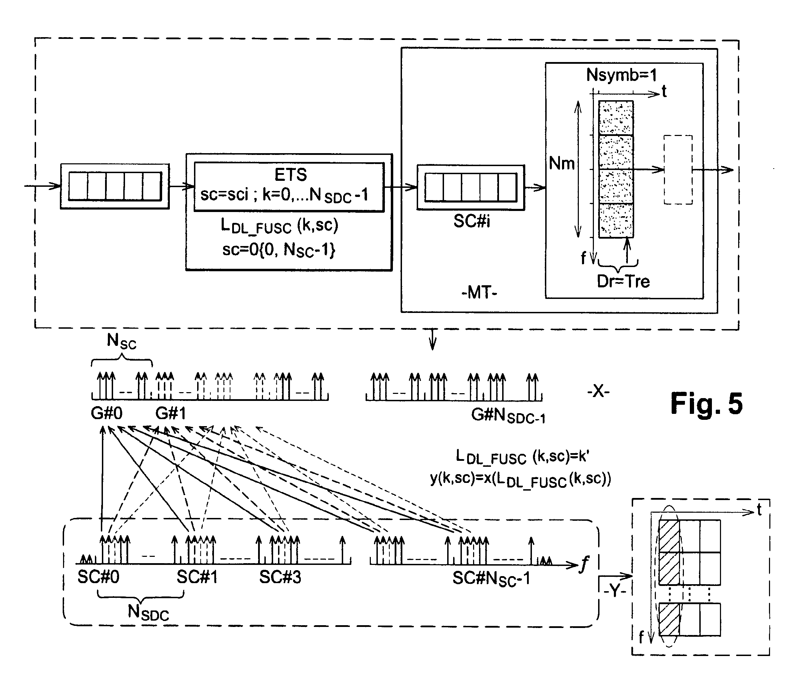

Le procédé de mappage est détaillé ci-après dans le cas du mode FUSC pour la voie descendante et illustré par la figure 5.

Les sous canaux sur la voie descendante en mode FUSC peuvent être constitués de symboles issus de différents groupes. Un OFDMA-slot peut donc être associé à plusieurs groupes. Pour le mode FUSC en voie descendante, les symboles de données adjacents sont regroupés en $N_{SDC}$ groupes de $N_{SC}$ symboles de données. La segmentation dans des sous canaux consiste à allouer à un sous canal un symbole de donnée issu de chaque groupe différent suivant une loi qui dépend du nombre de symboles de données par symbole OFDMA, c'est à dire de la taille de la transformée de Fourier du mode de transmission OFDM. Le sous canal est formé de $N_{SDC}$ symboles de données issus de chaque groupe.

$N_{SC}$ canaux sont ainsi formés où $N_{SC}$ correspond au nombre de symboles de données par groupe. Les pilotes sont répartis dans la trame OFDM (multiplex OFDM) de façon indépendante. La loi d'allocation des symboles de données dans les sous canaux est à deux dimensions où sc est l'indice du sous canal $s_c$={0, Nsc-1} et k l'indice de position du symbole dans le sous canal k={0, $N_{SDC}$-1}. La loi $L_{DL\_FUSC}(k, S_c)$ fournit, pour le symbole à la position k dans le sous canal $s_c$, la position d'origine du symbole en amont du procédé d'entrelacement ETS dans le bloc de données formé par $N_{SDC}$x $N_{SC}$ symboles de données et indicés de 0 à $N_{SDC}$x $N_{SC}$-1. Les indices $s_c$ et k correspondent à la position de ce symbole dans le sous canal d'indice se (Y(k,sc)=X(k'=$L_{DL\_FUSC}$(k, $s_c$)).

La loi d'allocation des symboles de données dans les sous canaux est donnée par :

$$L_{DL\_FUSC}(k,s_c) = Nsc \cdot n(k,s_c) + \left[ Ps_c([n(k,s_c)]_{Nsc} + DL\_perm\_base) \right]_{N_{SC}}$$

$$n(k,s_c) = \left[ k + 13 \cdot s_c \right]_{N_{SDC}}$$

$$k' = L_{DL\_FUSC}(k,s_c), k' = \{0,....N_{SDC} \times N_{SC} - 1\},$$

$$k = \{0, N_{SDC} - 1\}, sc = \{0, N_{SC} - 1\}$$

$$Y(k,s_c) = X(L_{DL\_FUSC}(k,s_c))$$

$Ps_c$(k) est une loi bijective correspondant à un motif d'entrelacement de taille Nsc décrite sous la forme d'un vecteur de taille Nsc pour k variant de 0 à Nsc-1. La loi $Ps_c$ varie pour chaque sous canal considéré d'indice $S_c$ et résulte d'une rotation circulaire gauche de $S_c$ déduite d'une loi d'allocation de base dite PL_perm_base. DL_perm_base est un vecteur de taille Nsc qui fait correspondre à l'indice k, la position du symbole d'origine $Ps_c$(k).

La loi de permutation varie avec la taille de la transformée de Fourier de la modulation OFDM et sa taille correspond au nombre de sous canaux par symbole OFDMA. Les paramètres de transmission pour le mode FUSC sont donnés pour différentes tailles de la transformée de Fourier dans le tableau 1 de l'annexe A. La taille d'un sous canal est fixe. Elle est dimensionnée par rapport à la taille de la trame, le débit, la taille des groupes de symboles OFDM et elle est indépendante du mode de transmission OFDM (taille FFT, débit).

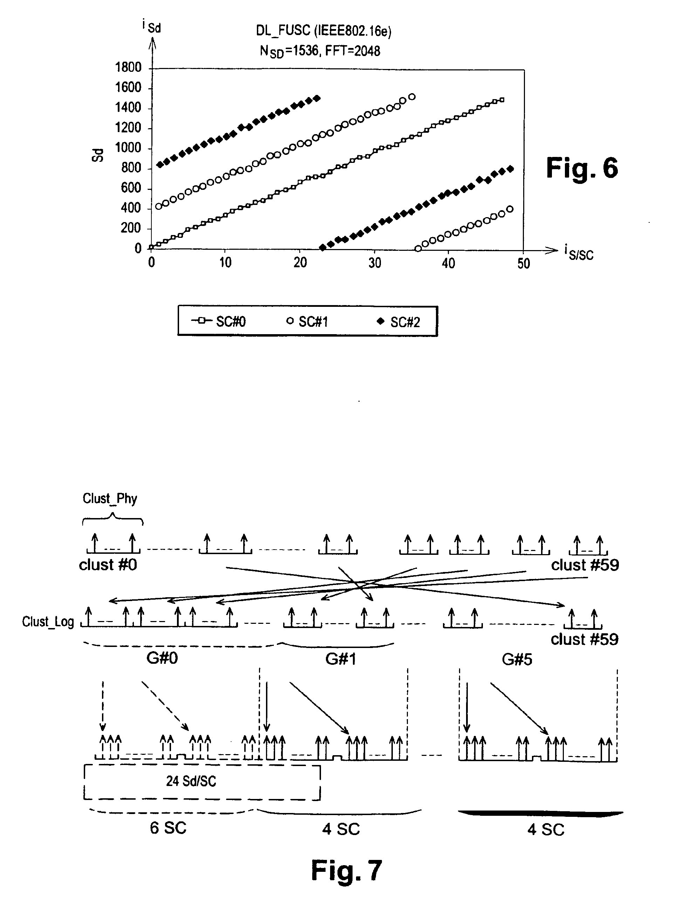

La figure 6 donne la répartition des symboles de données dans les sous canaux suivant la loi $L_{DL\_FUSC}$(k,$s_c$) pour une taille de FFT égale à 2048. L'axe des ordonnées correspond à l'indice i $s_d$ des symboles de donnée dans un symbole OFDM. L'axe des abscisses correspond à l'indice $i_{S/SC}$ de position du symbole pour un sous canal donné. Cet indice évolue de zéro à $N_{SDC}$-1=47. Les trois courbes correspondent à trois sous canaux différents désignés par SC#i.

Le procédé d'allocation est plus complexe qu'un entrelacement matriciel précédant l'opération MT en vertu de l'équation $L_{DL\_FUSC}$(k,$s_c$) qui tient compte d'une permutation de base DL_perm_base et des indices k et $s_c$ utilisés dans l'équation pour former les sous-canaux.

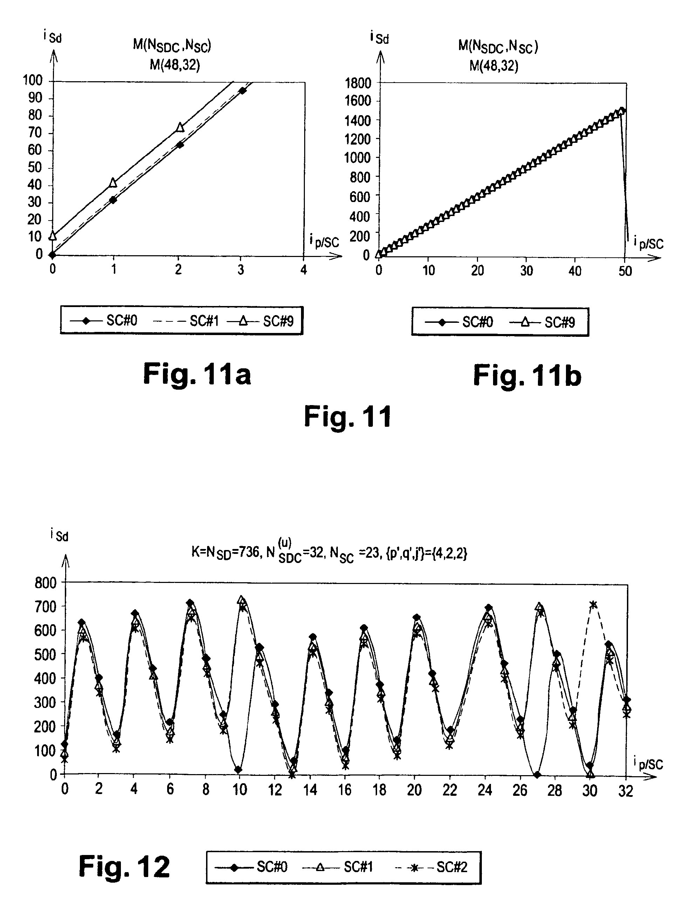

Par ailleurs, le procédé assure une meilleure dispersion des données entre canaux adjacents comme illustré par les figures 6 et 11.

Le module de mappage peut en outre insérer des symboles pilotes répartis dans chaque sous canal pour permettre une égalisation OFDM à la réception à partir des pilotes reçus. L'insertion de symboles pilotes répartis peut être complétée par l'insertion d'un préambule OFDM.

Les symboles mappés sont ensuite modulés par un modulateur OFDM en considérant chaque ensemble de Nsc sous-canaux associés à un symbole OFDM.

Le procédé de mappage est détaillé ci-après dans le cas du mode PUSC du standard Wi-Max (IEEE802.16e) et illustré par la figure 7.

Les symboles de données Sd sont segmentés en clusters physiques de taille fixe contenant douze symboles de données et deux pilotes par cluster physique Clust_Phy : un cluster physique comprend 14 sous porteuses dont 12 sous porteuses de données et 2 sous porteuses pilotes. Il y a en tout 60 clusters physiques et la taille de la FFT est de 1024.

La position des pilotes dépend de l'indice du symbole OFDMA dans l'OFDMA slot (pair ou impair). Ces clusters physiques sont redistribués en clusters logiques Clust_Log suivant une loi de permutation variant de zéro à Ncp-1 avec Ncp correspondant au nombre de clusters Ncp=Nused/14=$N_{SD}$/12 et comportant Ncp éléments (Séquence RS). Le nombre de clusters est tel que le nombre total de symboles de données Sd est égal au nombre de symboles de données par symbole OFDM ($N_{SD}$). Ensuite ces clusters logiques sont segmentés en six groupes G#0,..,G#5 pouvant prendre deux tailles (6,4) possibles selon que l'indice du groupe est pair ou impair g={0, ....5}. L'allocation des clusters logiques de chaque groupe dans les sous canaux exploite deux séquences d'allocation suivant la taille des groupes et leur indice (pair ou impair). Chaque sous canal SC contient deux clusters logiques d'un même groupe. La génération des clusters logiques s'apparente à un entrelacement de clusters physiques. La génération des groupes s'apparente à une pré-segmentation pouvant prendre deux valeurs possibles de taille de segmentation. La répartition des clusters logiques dans les sous canaux est équivalente à deux lois d'entrelacement indépendantes appliquées suivant l'indice du cluster logique, suivie d'une segmentation telle que chaque sous canal contienne deux clusters logiques d'un même groupe. Les lois d'entrelacement s'appliquent au sein d'un groupe. Le nombre de clusters et le nombre de sous canaux considérés varient avec le mode de transmission OFDM alors que la taille des clusters et la taille des sous canaux sont indépendantes du mode de transmission OFDM comme illustré par le tableau 2 en annexe A. Le nombre de sous canaux varie avec le nombre de porteuses de données par symbole OFDMA qui lui-même dépend de la taille de la bande de transmission et de la taille de la FFT (2048, 1024, 512) du modulateur OFDM. La taille (24 Sd/SC) d'un sous canal est fixée et n'est pas paramétrable. Pour déterminer cette taille de sous canal, il a été considéré les contraintes associées à l'algorithme de codage correcteur d'erreur pour satisfaire plusieurs types de codage correcteur d'erreurs (turbo-codes, code convolutif, rendement de code). Un bloc de codage $K_h^{(u)}$ correspond à un ou plusieurs sous canaux.

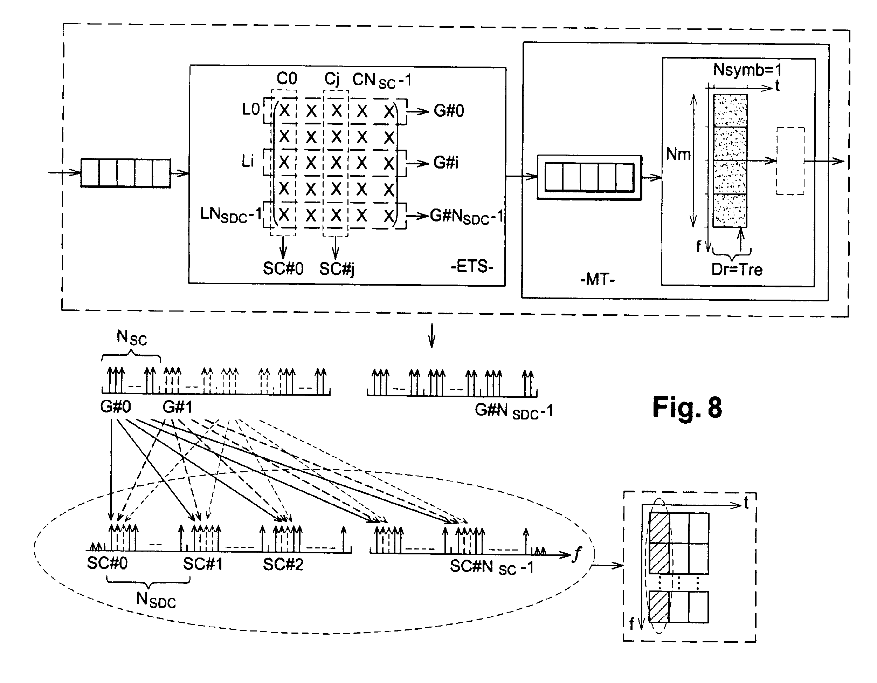

Un deuxième mode de réalisation d'un système de l'art antérieur est décrit et illustré par la figure 8. La chaîne d'émission de ce système comprend un entrelaceur symbole ETS de type matriciel ($N_L$x$N_c$)=($N_{SDC}$ x $N_{SC}$) qui permet d'entrelacer les symboles en amont du module de mappage MT.

Un entrelacement matriciel consiste à écrire les données dans une matrice de taille ($N_L$,$N_c$) ligne par ligne et à les lire colonne par colonne.

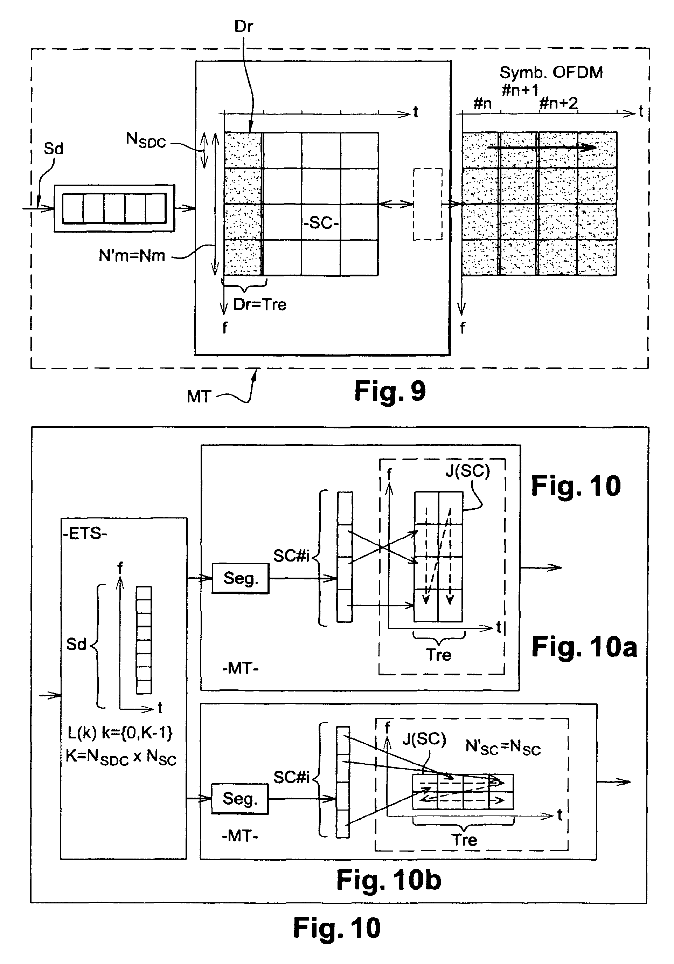

Le dimensionnement conjoint entre l'entrelaceur et le module de mappage ainsi que le choix du type matriciel de l'entrelaceur permettent d'effectuer une allocation des symboles de $N_{SDC}$=$N_L$ groupes différents, désignés par G#n, dans $N_{SC}$=$N_C$ sous canaux désignés par SC#m. La ligne n°i de la matrice correspond à un groupe G#i de taille $N_{SC}$ tandis que la colonne j de la matrice de taille $N_{SDC}$ est constituée par une donnée de chaque groupe en position j. L'allocation des symboles dans des sous canaux de taille $N_{SDC}$ résulte donc du choix conjoint d'un entrelaceur de type matriciel, d'un dimensionnement du nombre de lignes égal à la taille d'un sous canal, d'un dimensionnement du nombre de colonnes égal au nombre de sous canaux du module de mappage et d'une segmentation des symboles de sortie de l'entrelaceur dans des sous canaux de taille $N_{SDC}$ par le module de mappage. La répartition est réalisée par la mise en oeuvre conjointe de l'entrelaceur ETS et du module de mappage MT. Le module MT effectue une segmentation des symboles de données en sortie de l'entrelaceur matriciel avec une taille de segment ($N_{SDC}$) qui correspond au nombre d'éléments par colonne de la matrice pour former $N_{SC}$ sous-canaux élémentaires SC#j constitués de $N_{SDC}$ symboles de données issus de $N_{SDC}$ groupes différents. Les éléments de la colonne j, Cj, correspondent aux symboles de données en jème position de chaque groupe G# et décrivent les éléments du sous canal j. Ces sous canaux SC#j sont ensuite répartis séquentiellement en fréquence pour former un bloc Dr identique à une trame élémentaire OFDM Tre formée d'un seul symbole OFDM et de $N_{SC}$ sous-canaux SC#0,... SC#$N_{SC}$-1 comme illustré par la figure 9. Le module de mappage peut en outre insérer des symboles pilotes dans chaque sous canal pour effectuer une égalisation OFDM à la réception à partir des pilotes reçus. L'insertion de symboles pilotes répartis peut être complétée par l'insertion d'un préambule OFDM. Ce type de mappage peut être utilisé pour des modulations à porteuses multiples typiquement OFDM incluant une technique d'accès, par exemple OFDMA. Les symboles associés à un utilisateur #i sont dans un groupe G#i formé de #$N_{SC}$ symboles de données correspondant à la ligne #i de la matrice. $N_{SDC}$ groupes de symboles sont considérés successivement et soumis à l'entrelacement matriciel suivi du mappage des symboles. Les symboles de données mappés en entrée du modulateur OFDM sont segmentés dans $N_{SC}$ sous canaux constitués de $N_{SDC}$ symboles de données associés à $N_{SC}$ utilisateurs (groupes de données indépendants) et ces sous canaux sont successivement répartis en fréquence.

Donc, selon les techniques connues de l'art antérieur, les symboles de données, éventuellement entrelacés, sont segmentés dans N'm sous canaux de taille $N_{SDC}$ et répartis dans le plan temps-fréquence par le module de mappage MT. La répartition dans le plan temps-fréquence peut se dérouler soit au sein d'un bloc fréquentiel de sous canaux puis par bloc selon l'axe des temps comme illustré par les figures 9 et 10a) soit au sein d'un bloc temps-fréquence de sous canaux puis par bloc de sous-canaux selon les axes temporel et fréquentiel, comme illustré par les figures 4 et 10b).

La taille $N_{SDC}$ des sous canaux qui correspond à l'unité élémentaire de transmission en fréquence pour les procédés OFDM dépend de la taille de la trame et de la taille minimale des blocs de codage. Lorsque les symboles OFDM sont associés à plusieurs utilisateurs $u_1, u_2, .... u_n$ ou, par exemple, lorsque les symboles sont associés à un même utilisateur mais correspondent à des services différents (VoIP, vidéo, etc), le mappage est tel qu'un sous canal contient soit des symboles d'un même utilisateur ou correspondant à un même service soit des symboles associés à des utilisateurs/services différents.

Dans les systèmes de l'art antérieur, la taille $N_{SDC}$ des sous canaux est fixe, elle n'est pas paramétrable.

Les techniques de mappage symbole connues ont pour inconvénient de diminuer, voire d'annuler l'effet de diversité lié à la dispersion minimale entre symboles introduite par l'entrelaceur symbole. En effet, il se peut que la dispersion minimale entre symboles entrelacés d'un bloc K diminue suite au mappage des symboles entrelacés dans des sous canaux répartis en temps et en fréquence. Ceci vient du fait que la répartition des sous canaux dans le plan temps fréquence peut rapprocher des symboles préalablement distants d'au moins une distance minimale s après entrelacement du fait de leur positionnement effectué par le module de mappage dans des sous canaux adjacents en temps ou en fréquence. Cette diminution de la dispersion après le procédé de mappage est illustrée par la figure 11 qui correspond au même mode de transmission OFDM que celui du mode FUSC illustré par la figure 6.

La figure 11 donne une représentation de la répartition des symboles dans les sous canaux suite au mappage de symboles entrelacés par un entrelaceur matriciel $M(N_{SDC}, N_{SC})$ dont le nombre de lignes correspond à la taille d'un sous canal $N_{SDC}$ et le nombre de colonnes correspond au nombre de sous canaux $N_{SC}$.

La figure 11b donne l'indice $i_{Sd}$ des symboles après mappage dans les sous canaux SC#0 et SC#9, avec $N_{SDC}=48$ et $N_{SC}=32$ en fonction de l'indice $i_{p/SC}$ des porteuses pour un sous canal. Pour chaque sous canal, l'indice des porteuses prend ses valeurs de zéro à $N_{SDC}-1=47$. La figure 11a) est une loupe de la figure 11b pour les premières valeurs d'indices : l'axe des abscisses est limité aux valeurs d'indice de zéro à quatre pour pouvoir visualiser la dispersion entre symboles situés à la même position dans les sous canaux SC#0 et SC#9 et constater que cette valeur est de dix. Entre les sous canaux adjacents SC#0 et SC#1, cette valeur est seulement de un. Ces valeurs de dispersion peuvent être calculées de manière analytique sachant que la loi d'entrelacement matriciel est donnée par l'équation suivante :

$$L_M(k) = E\left\{\frac{k}{N_{SDC}}\right\} + N_{SC} \cdot [k]_{N_{SDC}}$$

$$k = \{0, ....., N_{SDC} - 1\}$$

La dispersion entre sous canaux adjacents est donnée par l'équation suivante :

$$\Delta L_M(s) = \underset{k < N_{SDC}}{Min} \left| L_M(k+s) - L_M(k) \right|$$

$$s = N_{SDC} \cdot m$$

Le premier terme de $L_M(k)$ fournit donc la dispersion entre sous canaux adjacents. Deux symboles à la même position de porteuse dans deux sous canaux différents présentent une dispersion égale à la variation d'indice entre ces sous canaux.

Ainsi, l'entrelacement matriciel permet d'obtenir une dispersion de trente deux au sein d'un sous canal. Mais si le mappage des sous canaux est effectué d'abord en temps alors la dispersion entre deux canaux adjacents en temps n'est plus que de un. Cette configuration entrelacement matriciel/mappage diminue voire annule selon l'axe temporel l'effet de dispersion introduit par l'entrelaceur. La publication US 2005/265469 A1 décrit un système de mappage où la taille des sous canaux est déterminée de façon fixe ou arbitraire pour un nombre de flux donné.

**Exposé de l'invention**

L'invention propose un procédé pour mapper des symboles de données entrelacés en entrée d'un modulateur multi porteuse qui permet d'atténuer l'impact négatif du mappage sur la diversité introduite au préalable par l'entrelacement des symboles de données.

Ainsi, l'invention a pour objet un procédé pour mapper en entrée d'un modulateur multi porteuse des symboles de données entrelacés par bloc de K symboles, dans des sous canaux de taille égale à $N_{SDC}$ porteuses consécutives répartis sur un ou plusieurs symboles multi porteuses, $N_{SDC}$ étant sous-multiple de K, tel que la taille $N_{SDC}$ des sous canaux est déterminée en fonction d'une diversité de motifs d'entrelacement des symboles entre sous canaux..

L'invention a en outre pour objet un module de mappage pour la mise en oeuvre d'un procédé selon l'invention.

Ainsi, un module de mappage selon l'invention est adapté pour mapper en entrée d'un modulateur multi porteuse des symboles de données entrelacés par bloc de K symboles, dans des sous canaux de taille égale à $N_{SDC}$ porteuses consécutives répartis sur un ou plusieurs symboles multi porteuses, $N_{SDC}$ étant sous-multiple de K. Le module est en outre adapté pour déterminer une taille des sous canaux en fonction d'une diversité de motifs d'entrelacement des symboles entre sous canaux.

En transmission multi porteuses, un symbole multi porteuse est transmis sur un temps symbole (time slot) et occupe une bande B. Un sous canal correspond généralement au regroupement de plusieurs porteuses sur un temps symbole multi porteuses. La taille d'un sous canal correspond au nombre de porteuses regroupées dans le sous canal.

Lors de l'étape de mappage, les symboles issus de l'étape d'entrelacement sont segmentés dans différents sous canaux qui sont eux-mêmes répartis en temps et en fréquence. Typiquement, un sous canal contient les symboles d'un même utilisateur. Ainsi, en cas de pluralité d'utilisateurs, les symboles d'utilisateurs différents sont segmentés dans des sous canaux différents. Dans le cas de services différents pour un même utilisateur, les symboles respectifs des différents services sont typiquement segmentés dans différents sous canaux. Une telle segmentation peut par exemple permettre de  distinguer la qualité de service (QoS) entre services en allouant plus de sous canaux à un service donné qu'à un autre ( ou en réservant une certaine bande de fréquence à un service donné).

La diversité de motifs d'entrelacement des symboles entre sous canaux est évaluée par une mesure des différences entre les motifs d'entrelacement des symboles contenus dans ces sous canaux, c'est-à-dire une mesure des différences entre les distributions des indices des symboles dans les sous canaux. Cette mesure peut être limitée entre sous canaux adjacents ou élargie à des sous canaux non adjacents.

Le procédé et le dispositif conformes à l'invention résolvent le problème posé. En effet, la prise en compte du mappage des symboles entrelacés dans les sous canaux répartis en temps, en fréquence ou en temps et en fréquence, c'est-à-dire respectivement entre plusieurs symboles multi porteuses pour une même bande de fréquence, au sein d'un même symbole multi porteuses ou entre plusieurs symboles multi porteuses, pour dimensionner la taille des sous canaux permet d'écarter les valeurs envisageables qui introduisent une répétition de motif d'entrelacement de symboles entre sous canaux adjacents voire entre sous canaux non adjacents et plus ou moins distants entre eux en fonction du mode de réalisation. Un procédé selon l'invention assure une diversité maximale en entrée du modulateur multi porteuses. De manière particulièrement avantageuse, un procédé selon l'invention permet ainsi une répartition quelconque des sous canaux dans le plan temps fréquence tout en assurant une diversité maximale temps fréquence de motifs à la seule condition que les sous canaux aient la taille déterminée selon l'invention pour la loi d'entrelacement L(k) considérée. En outre, en assurant une combinaison optimale de l'entrelacement et du mappage via une diversité de motifs d'entrelacement et une dispersion maximale entre symboles au sein d'un sous canal, un procédé selon l'invention permet d'atteindre la diversité maximale temps fréquence et donc de maximiser la capacité du système et ce, quel que soit le nombre d'utilisateurs. En effet, l'atteinte d'une diversité maximale temps fréquence assure une lutte optimale contre les effets de corrélation introduit par le canal de transmission. Par conséquent, un procédé selon l'invention permet d'améliorer les performances à la réception évaluées par un taux d'erreur binaire du fait des traitements de demappage et de desentrelacement, inverses respectivement du mappage et de l'entrelacement symbole, qui permettent d'atténuer les perturbations introduites par le canal en les étalant dans le plan temps fréquence ce qui se traduit par une décorrélation des symboles transmis.

La détermination de la taille des sous canaux peut typiquement résulter de comparaisons de différences de motifs d'entrelacement entre sous canaux adjacents pour différentes tailles de sous canaux et de la sélection d'une taille pour laquelle les différences sont les plus significatives, c'est-à-dire la diversité la plus grande.

Selon un mode de réalisation particulier, un procédé pour mapper en entrée d'un modulateur multi porteuse des symboles de données entrelacés selon l'invention est tel que la diversité de motifs d'entrelacement des symboles entre sous canaux est évaluée pour des groupes de sous canaux distants entre eux d'au plus un sous canal.

Ce mode de réalisation permet de limiter les opérations d'évaluation de la diversité en limitant les comparaisons de motifs pour un sous canal donné. Le mode de réalisation qui prend en compte dans la comparaison de motifs pour un sous canal donné, des canaux adjacents et des sous canaux éloignés d'un sous canal peut être plus particulièrement adapté à des lois d'entrelacement pseudo périodiques. par exemple les lois dont l'expression mathématique comporte un modulo. En particulier, l'évaluation de la diversité sur trois sous canaux distants entre eux d'au plus un sous canal permet d'éliminer les valeurs de la taille correspondant à la pseudo période..

Selon un mode de réalisation particulier, un procédé pour mapper en entrée d'un modulateur multi porteuse des symboles de données entrelacés selon l'invention est tel que les groupes sont composés de paires de sous canaux adjacents.

Ce mode de réalisation est plus particulièrement adapté à des lois d'entrelacement non pseudo périodiques, par exemple des lois dont l'expression mathématique ne comporte pas de modulo.

Selon un mode de réalisation particulier, un procédé pour mapper en entrée d'un modulateur multi porteuse des symboles de données entrelacés selon l'invention comprend :

- une première étape de calcul d'une fonction de dispersion $\Delta L(s)$ représentant la distance minimale entre les symboles d'entrée $(X(L(k)))$ en fonction de l'écart s entre symboles entrelacés $(Y(k+s),Y(k))$, pour une loi d'entrelacement donnée $L(k)$,
- une deuxième étape de pré-sélection de valeurs d'écart s', sous multiple de K, pour lesquelles les valeurs de dispersion remplissent un critère d'amplitude,

une troisième étape d'évaluation d'une diversité géométrique entre sous canaux pour les différentes valeurs d'écart présélectionnées s', la taille $N_{SDC}$ des sous canaux étant déterminée égale à une des valeurs d'écart pré-sélectionnées s' pour lesquelles la diversité géométrique est maximale.

Selon ce mode, le procédé évalue la diversité dans le plan fréquentiel lors d'une première étape selon un critère de dispersion entre symboles de données entrelacés selon une loi donnée puis évalue la diversité de motifs d'entrelacement selon un critère de diversité géométrique lors d'une troisième étape. L'enchaînement des étapes permet de limiter les calculs lors de la troisième étape aux seules valeurs possibles de la taille des sous canaux correspondant aux valeurs d'écart s' pré-sélectionnées lors de la deuxième étape. La loi d'entrelacement peut être fixée initialement ou elle peut correspondre à un choix parmi une liste de lois d'entrelacement. Dans ce cas, les étapes peuvent être répétées pour chacune des lois. Le procédé peut choisir une des lois soit à l'issue de la première étape en sélectionnant celle qui donne les meilleures valeurs de dispersion, soit à l'issue de la troisième étape en sélectionnant celle qui donne les meilleures valeurs de diversité géométrique. Selon ce mode, le procédé assure une combinaison optimale de l'entrelacement et du mappage via une dispersion maximale entre symboles au sein d'un sous canal et une diversité de motifs d'entrelacement. Un tel mode permet d'atteindre la diversité maximale temps fréquence.

Selon un mode de réalisation particulier, un procédé pour mapper en entrée d'un modulateur multi porteuse des symboles de données entrelacés selon l'invention est tel que, K est égale à la taille d'un symbole multi porteuses..

Le choix d'une profondeur K d'entrelacement égale à la taille d'un symbole multi porteuses permet de minimiser la latence qui ralentit le traitement à la réception

Selon un mode de réalisation particulier, un procédé pour mapper en entrée d'un modulateur multi porteuse des symboles de données entrelacés selon l'invention est tel que K est multiple de la taille d'un symbole multi porteuses..

Le choix d'une profondeur K d'entrelacement multiple de la taille d'un symbole multi porteuses permet d'augmenter l'effet de diversité introduit par l'entrelacement.

Les différents modes de réalisation précédents peuvent être combinés ou pas avec un ou plusieurs de ces modes pour définir un autre mode de réalisation.

L'invention a en outre pour objet un procédé d'émission adapté en ce qu'il comprend un procédé de mappage selon l'invention.

L'invention a en outre pour objet un émetteur de télécommunication adapté pour la mise en oeuvre d'un procédé selon l'invention.

Ainsi, un émetteur de télécommunication selon l'invention, comprend entre un modulateur générant des symboles de données et un modulateur multi porteuses générant des symboles multi porteuses, un entrelaceur d'un bloc de K symboles de données, un module de mappage selon un objet précédent.

L'invention a en outre pour objet un système de télécommunication adapté pour la mise en oeuvre d'un procédé selon l'invention.

Ainsi, un système de télécommunication selon l'invention, comprend un émetteur adapté selon un objet précédent et un récepteur.

**Liste des figures**

D'autres caractéristiques et avantages de l'invention apparaîtront lors de la description qui suit faite en regard de figures annexées données à titre d'exemples non limitatifs.

La figure 1 représente une chaîne d'émission/réception classique décrite en bande de base pour un système SYS selon l'art antérieur.

La figure 2 représente une chaîne d'émission/réception classique comprenant un entrelacement ETB effectué sur les données binaires et un entrelacement ETS effectué sur les symboles de données Sd décrite en bande de base pour un système SYS selon l'art antérieur.

La figure 3 est un schéma d'une technique de mappage selon l'art antérieur consistant à assigner un symbole différent de chaque groupe d'utilisateurs à chaque sous canal et à distribuer les sous canaux en temps et en fréquence de façon à mixer différents utilisateurs au sein d'un même symbole OFDM.

Les figures 4, 5, 6 et 7 se rapportent à un système de l'art antérieur conforme au standard IEEE 802.16e.

La figure 4 est un schéma du procédé de mappage.

La figure 5 est un schéma détaillé du procédé de mappage dans le cas du mode FUSC pour la voie descendante.

La figure 6 donne la répartition des symboles de données dans les sous canaux suivant la loi $L_{DL\_FUSC(k.sc)}$ pour le mode FUSC pour une taille de FFT égale à 2048.

La figure 7 est un schéma détaillé du procédé de mappage dans le cas du mode PUSC du standard Wi-Max (IEEE802.16e).

La figure 8 représente un autre mode de réalisation d'un procédé de mappage selon l'art antérieur relatif à un système qui comprend un entrelaceur symbole ETS de type matriciel.

La figure 9 est un schéma du procédé de mappage de la figure 8 détaillant la répartition des symboles dans le plan temps fréquence.

La figure 10 est un schéma d'un entrelaceur ETS suivi d'un module de mappage MT avec une répartition des sous canaux en fréquence puis en temps selon le module de mappage figure 10a) ou avec une répartition des sous canaux en temps puis en fréquence selon le module de mappage figure 10b).

La figure 11 est une représentation de la répartition dans le plan temps-fréquence des symboles dans les sous canaux suite au mappage de symboles entrelacés par un entrelaceur matriciel dont le nombre de lignes correspond à la taille d'un sous canal $N_{SDC}$ et le nombre de colonnes correspond au nombre de sous canaux $N_{SC}$ selon un procédé de l'art antérieur correspondant à un même mode de transmission OFDM que celui du mode FUSC illustré par la figure 6, elle illustre la diminution de la dispersion après le procédé de mappage.

La figure 12 représente la répartition des symboles de données entrelacés avec une loi d'entrelacement bloc de taille $K=N_{SD}=736$ de type turbo selon l'art antérieur dans trois sous canaux adjacents successivement en temps, elle illustre l'effet négatif du mappage sur les symboles.

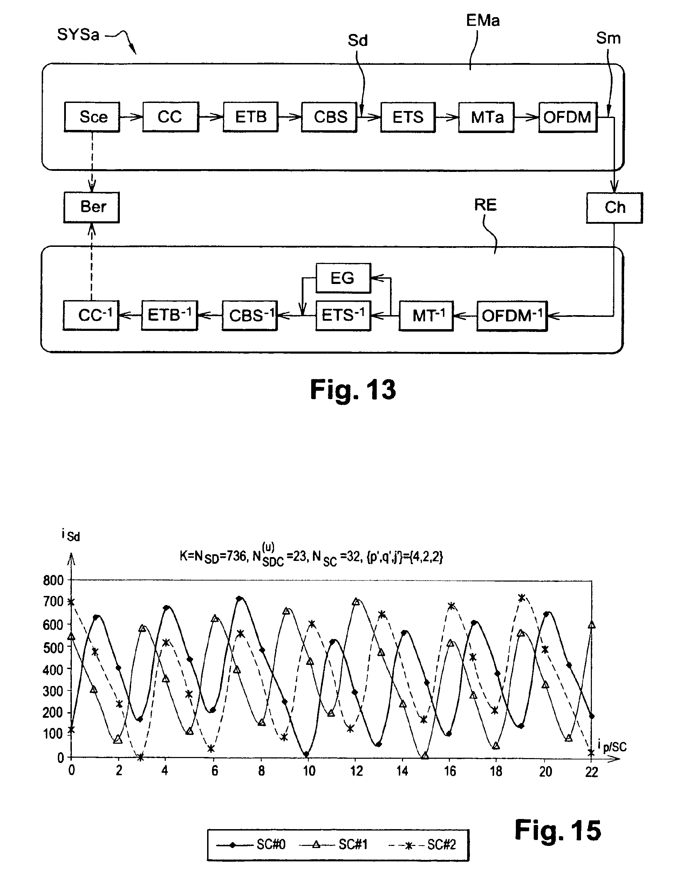

La figure 13 est un schéma de principe d'un exemple d'un système SYSa de transmission, décrit en bande de base, adapté selon l'invention pour mettre en oeuvre un procédé de mappage selon l'invention.

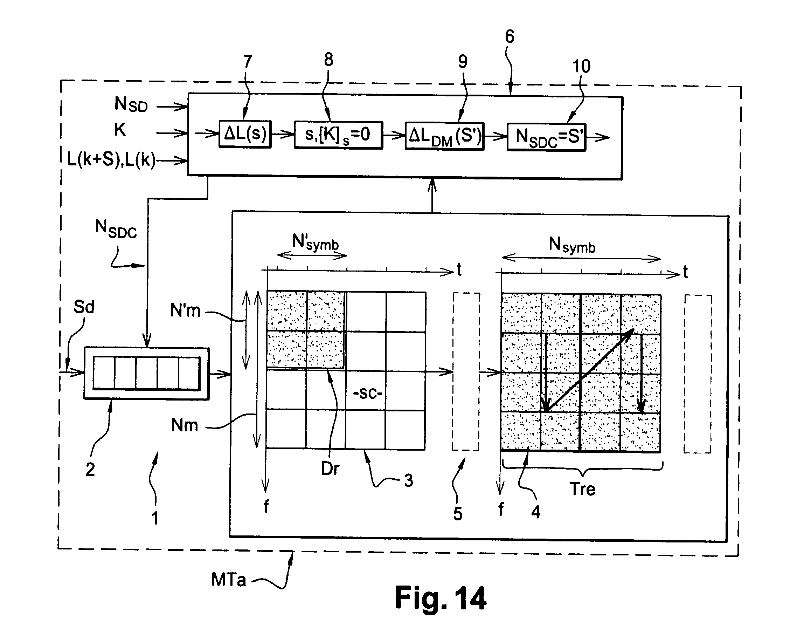

La figure 14 est un schéma d'un module de mappage MTa adapté selon l'invention pour mapper les symboles de données en entrée d'un modulateur OFDM selon un procédé de mappage selon l'invention.

La figure 15 représente la répartition des symboles dans trois sous canaux adjacents successivement en temps dans le cas d'un procédé de mappage selon l'invention, elle illustre l'effet du mappage sur les symboles de données entrelacés.

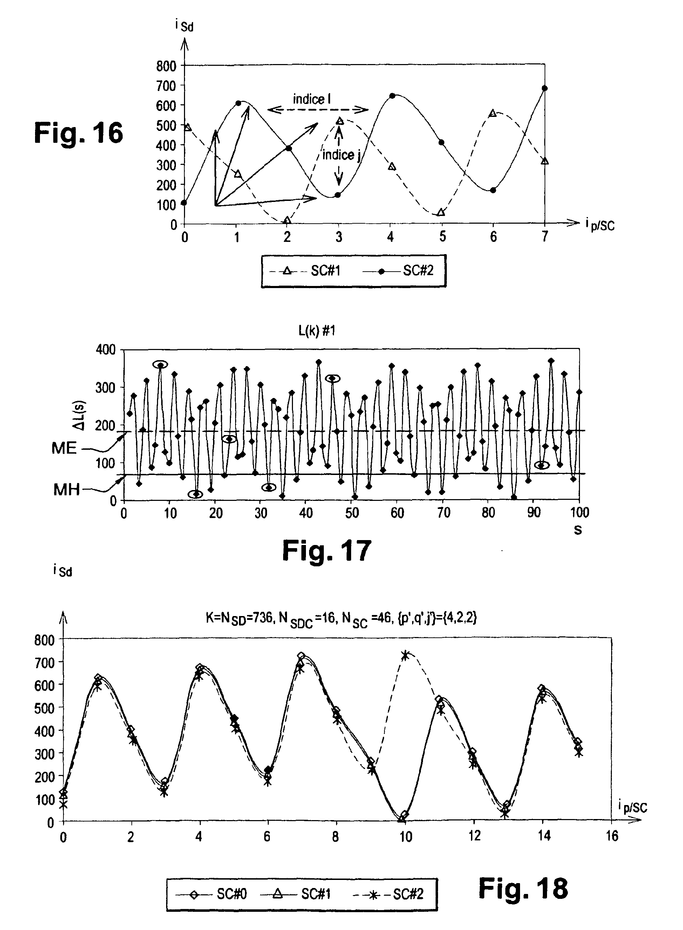

La figure 16 illustre la quantification de la diversité de motifs d'entrelacement entre sous canaux effectuée au moyen d'un critère de diversité géométrique mis sous forme d'une équation à double sommation sur les indices j et 1 dont l'effet est schématisé par trois flèches.

La figure 17 est une courbe représentant la dispersion $\Delta L(s)$ pour différente valeurs de s obtenue avec une loi d'entrelacement turbo $L_{TL}(k) = I_{p.q}^{(j)}(k)$ sur laquelle a été positionnée les valeurs de la médiane ME et de la moyenne harmonique MH.

Les figures 18 et 12 correspondent à une sélection par rapport à la courbe 17 respectivement de s'=16, d'où un nombre de sous canaux $N_{SC}=46$, et de s'= 32, d'où un nombre de sous canaux $N_{SC}=23$. s'= 16 et s'= 32 conduisent à une dispersion $\Delta L(s)$ inférieure à la moyenne harmonique MH, on observe bien des motifs d'entrelacement des symboles sans diversité entre sous canaux.

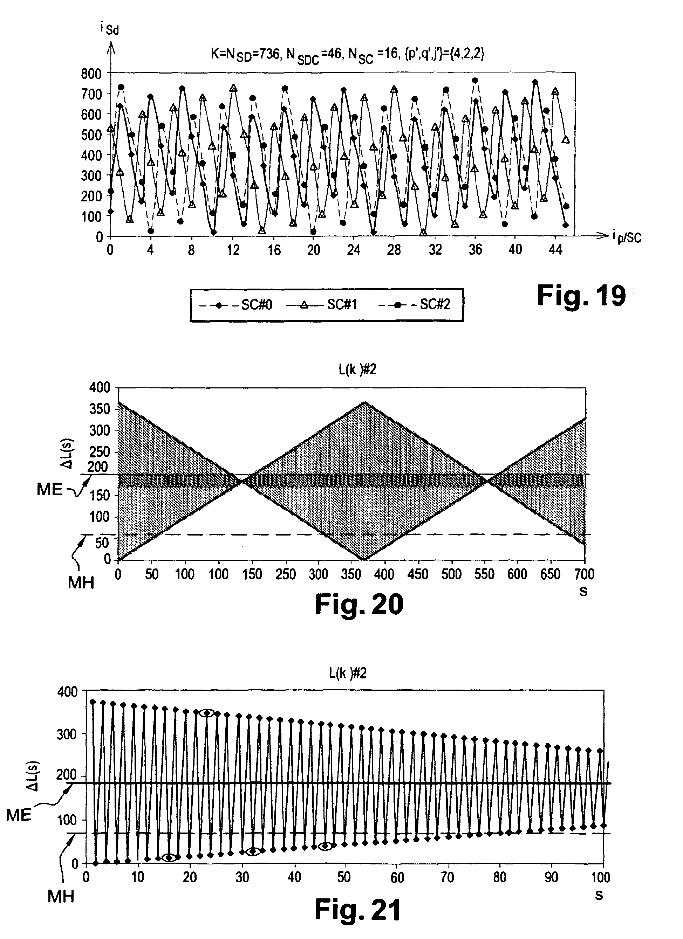

Les figures 19 et 15 correspondent à une sélection par rapport à la courbe 17 respectivement de s'= 46, d'où un nombre de sous canaux $N_{SC}=16$ et de s'=23, d'où un nombre de sous canaux $N_{SC}=32$. s'= 23 et s'= 46 conduisent à une dispersion $\Delta L(s)$ supérieure à la moyenne harmonique MH, on observe bien des motifs d'entrelacement des symboles avec diversité entre sous canaux.

La figure 3 représente un système SYS de transmission de type OFDM, connu de l'homme du métier. L'information issue d'une source Sce est codée au moyen d'un codeur CC. Les données sont ensuite mises sous la forme de symboles de données (cellules QAM, QPSK, ...) par un modulateur CBS. Les symboles de données sont entrelacés par un entrelaceur ETS. Les symboles de données entrelacés sont segmentés dans des sous canaux de taille élémentaire $N_{SDC}$ et mis en parallèle pour être répartis en temps et en fréquence en entrée d'un modulateur OFDM par le module de mappage. Le modulateur OFDM calcule des symboles OFDM à partir des symboles de données mappés en entrée.

Un procédé connu d'émission d'un signal multi porteuses, typiquement mis en oeuvre par l'émetteur EM du système SYS, comprend :

- une étape de modulation par le modulateur CBS générant des symboles (de données),
- une étape d'entrelacement d'un bloc de K symboles (de données) par l'entrelaceur ETS selon une loi L(k),
- une étape pour mapper par le module de mappage les symboles (de données) entrelacés dans des sous canaux de taille égale à $N_{SDC}$ porteuses consécutives répartis sur un ou plusieurs symboles OFDM, $N_{SDC}$ étant sous-multiple de K, selon une loi J(k).
- une étape de modulation OFDM par un modulateur OFDM générant des symboles OFDM.

K est multiple du nombre de symboles de données par symbole OFDM/OFDMA.

Lorsque l'étape de mappage tient compte des utilisateurs ou plus généralement distingue des groupes de symboles pouvant avoir une origine différente, par exemple issus de services différents, le procédé d'émission est dit de type OFDMA.

La figure 12 illustre l'effet négatif du mappage sur les symboles de données entrelacés dans le cas d'un procédé OFDMA selon l'art antérieur. Un procédé OFDMA assigne à des porteuses d'un même symbole OFDM, des symboles de données associés à différents utilisateurs (ou d'origines différentes, par ex. originaires de différents services). Les symboles de données d'un ou plusieurs utilisateurs sont alloués dans des sous canaux de taille élémentaire $N_{SDC}$. Ces sous canaux sont ensuite répartis en fréquence de façon à mixer différents utilisateurs au sein d'un même symbole OFDM comprenant $N_{SD}$ symboles de données et en temps entre symboles OFDM. La figure 12 donne l'indice $i_{Sd}$ des symboles après mappage dans les sous canaux SC#0, SC#1 et SC#2 avec $N^{(u)}_{SDC}$=32 et $N_{SC}$=23 en fonction de l'indice $i_{p/SC}$ des symboles pour un sous canal. La figure 12 représente la répartition des symboles dans les trois sous canaux SC#0, SC#1, SC#2 adjacents successivement en temps. Ces répartitions sont superposées sur la figure 12 car les trois sous canaux occupent les mêmes sous porteuses. La figure 12 illustre le cas d'un entrelacement bloc de taille K=$N_{SD}$=736 selon une loi d'entrelacement de type turbo décrite dans la demande de brevet PCT n° 2006072694 avec les paramètres (p',q',j')={4, 2, 2} suivi d'un mappage dans des sous canaux de taille $N^{(u)}_{SDC} = 32$ pour chaque utilisateur u. Cette succession d'entrelacement et de mappage engendre pour chaque utilisateur u une similarité de motif de répartition entre les sous canaux adjacents SC#0 et SC#1 d'une part et SC#1 et SC#2 d'autre part. Si ces sous canaux sont répartis suivant l'échelle des temps comme illustré par la figure 10b) et si le canal de propagation varie peu alors les performances du décodeur en réception sont limitées du fait de la répétition d'un motif d'entrelacement entre ces sous canaux adjacents.

Contrairement aux techniques connues, l'invention permet d'introduire une diversité temporelle et/ou fréquentielle de canal de propagation bénéfique pour le module de décodage en réception, en assurant des différences de motifs d'entrelacement entre sous canaux adjacents. En fréquence la probabilité est plus faible de ne pas exploiter la sélectivité fréquentielle naturelle du canal de propagation.

La figure 13 est un schéma de principe d'un exemple d'un système SYSa de transmission adapté selon l'invention pour mettre en oeuvre un procédé de mappage selon l'invention.

Le système de transmission SYSa est adapté selon l'invention en ce qu'il comprend un émetteur EMa adapté selon l'invention pour déterminer une taille des sous canaux en fonction d'une diversité de motifs d'entrelacement des symboles entre sous canaux. L'émetteur est adapté en ce que le module de mappage MTa est adapté pour mapper les symboles entrelacés dans des sous canaux de taille égale à $N_{SDC}$ porteuses consécutives répartis sur un ou plusieurs symboles multi porteuses, $N_{SDC}$ étant sous-multiple de K et déterminé par le module de mappage MTa en fonction d'une diversité de motifs d'entrelacement des symboles entre sous canaux.

La figure 14 est un schéma d'un module de mappage MTa adapté selon l'invention pour mapper les symboles de données en entrée d'un modulateur OFDM selon un procédé de mappage 1 selon l'invention. Le module de mappage MTa segmente 2 les symboles de données Sd entrelacés dans N'm sous canaux de taille $N_{SDC}$ et répartie 3, 4 les sous canaux dans le plan temps-fréquence. Le module de mappage peut en outre insérer 5 des pilotes dans chaque sous canal ou certains sous canaux à des positions déterminées pour permettre d'effectuer une égalisation OFDM à la réception à partir des pilotes reçus. L'insertion de pilotes peut être compléter par l'insertion 5 d'un préambule. Le module de mappage MTa détermine 6 la taille $N_{SDC}$ des sous canaux en fonction d'une diversité de motifs d'entrelacement des symboles entre sous canaux.

La figure 15 illustre l'effet du mappage sur les symboles de données entrelacés dans le cas d'un procédé de mappage selon l'invention. La figure 15 représente la répartition des symboles dans trois sous canaux adjacents successivement en temps. Ces répartitions sont superposées sur la figure 15 car les trois sous canaux occupent les mêmes sous porteuses. L'effet du mappage selon l'invention se traduit par une différence de motifs d'entrelacement entre sous canaux adjacents. Pour assurer une différence de motifs entre sous canaux adjacents, un procédé de mappage selon l'invention détermine une taille $N_{SDC}$ des sous canaux en prenant en compte une diversité d'entrelacement des symboles entre sous canaux. Selon l'exemple, la taille déterminée est égale à $N_{SDC}^{(u)} = 23$.

Pour déterminer la taille $N_{SDC}$ des sous canaux, le procédé 1 comprend plusieurs étapes selon un mode de réalisation préféré, illustré par la figure 14. Ces étapes se déroulent dans un module de calcul implémenté dans un FPGA, dans un microprocesseur ou dans tout moyen de calcul équivalent. Ces étapes peuvent, selon l'implémentation, se dérouler totalement ou partiellement en parallèle.

Selon une première étape 7, le procédé détermine les valeurs d'une fonction de dispersion $\Delta L(s) = Min_k|L(k)-L(k+s)|$. La fonction de dispersion $\Delta L(s)$ représente la distance minimale entre les symboles de données d'entrée (X(L(k+s), X(L(k)) de l'entrelaceur en fonction de l'écart s entre symboles entrelacés (Y(k+s),Y(k)), s variant de 1 à K. Cette fonction de dispersion est déterminée pour une loi d'entrelacement donnée L(k).

Une loi d'entrelacement L(k) d'un bloc de taille K donne l'ordre suivant lequel doit être lue, en sortie, une séquence d'entrée formée par K données indicées par un indice k variant de 0 à K-1. Soit $X(k)$ une séquence de symboles de données en entrée d'un entrelaceur de loi d'entrelacement L(k). Soit $Y(k)$ la séquence des symboles de données en sortie de l'entrelaceur. Alors $Y(k) = X(L(k))$ : la kième donnée Y de la séquence entrelacée ayant l'indice de position k-1 correspond à la donnée X d'indice L(k-1) de la séquence d'entrée X(0),...,X(K-1). La loi d'entrelacement L(k) est une fonction bijective qui prend ses valeurs dans l'espace S={0, ....K-1}. On définit la dispersion comme étant la plus petite distance après entrelacement entre deux indices de position associés à deux données d'entrée séparées par s-1 données, X(k) et X(k+s). La fonction de dispersion est donnée par la relation $\Delta L(s) = Min_{k,k\in S}|L(+s)-L(k)|$ pour s variant de 1 à K. La fonction $|x|$ fournit la valeur absolue de x.

Selon un mode de réalisation selon lequel K est égal à la taille $N_{SD}$ d'un symbole multi porteuse, le procédé limite les calculs de la fonction de dispersion pour s variant de 1 à K/2. En effet, la taille d'un sous canal est au maximum égale à la moitié de la taille d'un symbole multi porteuses pour pouvoir effectuer un mappage des symboles dans des sous canaux répartis en temps et/ou en fréquence. Lorsque K est un multiple de la taille d'un symbole multi porteuse, alors le procédé peut limiter les calculs de la fonction de dispersion pour s variant de 1 à $N_{SD}/2$, avec $N_{SD}$ le nombre de symboles de données par symboles multi porteuses. Finalement, que K soit égal à $N_{SD}$ ou soit un multiple de $N_{SD}$, le procédé peut limiter les calculs de la fonction de dispersion pour s variant de 1 à $N_{SD}/2$.

Selon une deuxième étape 8, le procédé pré-sélectionne des valeurs de s sous multiples de K pour lesquelles les valeurs de dispersion remplissent un critère d'amplitude.

Selon un premier mode de réalisation, le critère d'amplitude correspond à un maximum relatif de la dispersion. Les valeurs s' pré-sélectionnées, égales aux valeurs des abscisses correspondant à ces maximums relatifs, correspondent aux différentes tailles envisageables pour les sous canaux. Le procédé détermine les valeurs de s sous multiples de K en utilisant par exemple une fonction modulo : l'ensemble des sous multiples de K est égal à l'ensemble des valeurs de s pour lesquelles $[K]_s=0$. Ces valeurs sont notées s'. Pour ces différents valeurs de s', le procédé détermine la valeur de la dérivée de la fonction de dispersion. Si cette valeur est nulle, la fonction de dispersion présente un maximum relatif pour la valeur de s' considérée.

Selon un deuxième mode de réalisation, le critère d'amplitude correspond à un seuil : le procédé pré-sélectionne des valeurs de s sous multiples de K pour lesquelles la dispersion dépasse un seuil S. Ce seuil S peut correspondre à la moyenne harmonique MH de la dispersion calculée sur $N_{SD}/2$ échantillons (la moitié de la taille d'un symbole multi porteuse afin de pouvoir considérer au moins deux sous-canaux). La moyenne harmonique MH est égale à l'inverse de la moyenne arithmétique des inverses des observations :

$$\frac{1}{MH} = \frac{1}{N}\sum_{s=0}^{N-1}\frac{1}{|\Delta L(s)|^2},$$

avec $N=N_{SD}/2$. Ce seuil S peut être fixé selon un calcul analytique, être fixé de manière arbitraire ou prendre la valeur d'un paramètre.

Selon une troisième étape 9, le procédé évalue une diversité géométrique pour les différentes valeurs d'écart s' pré-sélectionnées.

Selon un mode de réalisation, le procédé évalue une diversité géométrique pour une valeur d'écart s' donnée, en calculant $\Delta L_{DM}(s')$ qui est une fonction qui quantifie la diversité géométrique des lois d'entrelacement sous la forme d'une dispersion moyennée sur plusieurs valeurs de s. Cette fonction est définie par la relation :

$$\Delta L_{DM}(s') = \underset{k}{Median}\left\{\frac{\sum_{j=1}^{N_{sc}^0-1}}{\left(N_{sc}^0-1\right)}\left(\frac{\sum_{l=0}^{s'-1}\left|L(k+j\cdot s')-L(k+l)\right|}{s'}\right)\right\}$$

avec Median la fonction qui calcule la valeur médiane de l'ensemble des valeurs obtenues en faisant varier k de 0 à K/s'-1.

L'indice j permet d'intégrer plusieurs sous canaux dans le calcul d'une dispersion moyenne. Si j est fixé à zéro, $\Delta L_{DM}(s)$ fournit la dispersion moyenne au sein d'un sous canal quel que soit l'indice du sous canal. Ce paramètre est donné par :

$$\Delta L_{DM}^{int}(s') = \underset{k}{Median}\left\{\frac{1}{s'}\sum_{l=0}^{s'-1}\left|L(k)-L(k+l)\right|\right\}$$

Si l'indice 1 est fixé à zéro, $\Delta L_{DM}$ fournit la dispersion moyenne entre sous canaux en considérant la même position au sein de chaque sous canal. Ce paramètre est donné par:

$$\Delta L_{DM}^{s_c^0}(s') = \underset{k}{Median}\left\{\frac{\sum_{j=1}^{N_{sc}^0}\left|L(k+j\cdot s')-L(k)\right|}{N_{sc}^0}\right\}$$

Selon un mode de réalisation particulier, le procédé considère quatre sous canaux adjacents pour ce calcul ce qui limite la valeur maximale de j à $N_{sc}^0=4$. Des valeurs plus élevées ne permettent pas de tenir compte d'une diversité de motif car la moyenne ne prend pas en compte la notion d'ordre des sous canaux. Si j et 1 varient simultanément, $\Delta L_{DM}(s)$ fournit la dispersion globale entre sous canaux intégrant la dispersion moyenne intrinsèque au sein de chaque sous canal et la dispersion moyenne entre $N_{sc}^0=4$ sous canaux. Toutes les positions possibles entre sous canaux sont considérées pour quantifier une dispersion à diversité de motif.

La diversité géométrique peut être évaluée de manière équivalente en la quantifiant différemment. Par exemple, pour chacune des valeurs s' pré-sélectionnées, l'évaluation peut être limitée à une comparaison entre sous canaux des m premiers symboles entrelacés, avec m petit devant s', par exemple quatre, cinq, dix,... , à la détermination du plus petit indice des premiers symboles entrelacés de chacun des sous canaux, à prendre comme référence le sous canal comportant le symbole entrelacé de plus petit indice, à soustraire de chacun des indices des symboles entrelacés considérés des autres sous canaux la valeur du plus petit indice, à déterminer les différences d'indice des symboles entrelacés du sous canal de référence avec les indices des symboles entrelacés des autres sous canaux pour une même valeur de position k dans un sous canal.

Selon une quatrième étape 10, le procédé détermine la taille $N_{SDC}$ des sous canaux en sélectionnant parmi les valeurs d'écart s' pré-sélectionnées, une des valeurs s' pour laquelle la diversité géométrique est maximale.

La valeur de s' sélectionnée conduit à une diversité de motif d'entrelacement entre sous canaux. Cette diversité est assurée via une maximisation de la dispersion pour $\Delta L(s=s')$ et une diversité de motif géométrique entre plusieurs sous canaux adjacents, ou éloignés entre eux, par exemple d'au plus trois sous canaux, estimée à l'aide du paramètre $\Delta L_{DM}(s=s')$.

Cette sélection qui dépend de la loi d'entrelacement conduit à une répartition optimale des sous canaux avec un ordre de diversité maximale temps-fréquence des sous canaux. Cet ordre de diversité ne dépend que la loi d'entrelacement L(k) et de la taille des sous canaux $N_{SDC}^{(u)}=s'$.

Deux exemples de mise en oeuvre d'un procédé selon l'invention sont décrits ci-après en regard des courbes des figures 12, 15, 17, 18, 19 et des courbes des figures 22 et 23 obtenues avec un système d'émission/réception OFDM mettant en oeuvre un tel procédé.

Le premier exemple se rapporte à un système SYSa pour lequel l'entrelaceur ETS met en oeuvre une loi d'entrelacement L(k) à structure turbo décrite dans la demande de brevet PCT n° 2006072694 préalablement citée.

La loi d'entrelacement L(k) fournit la position du symbole de sortie en position k dans la séquence d'entrée en amont de l'entrelacement (y(k)=x(L(k)).

La loi#1 est notée $L_{TL}(k) = I_{p,q}^{(j)}(k)$,

Elle dépend de trois paramètres entiers (p, q , j) correspondant à l'itération d'un algorithme de base 1 et de la taille du bloc d'entrelacement K. $L_{TL}(k) = I_{p,q}^{(j)}(k)$ est décrite par l'équation suivante :

$$L_{TL}(k) = I_{p,q}^{(j)}(k) = \left[ K - p + k + q \cdot p \cdot \left[ -k - p \cdot I_{p,q}^{(j-1)}(k) \right]_K \right]_K$$

$$j = 1 \longrightarrow L_{TL}(k) = I_{p,q}(k) = \left[ K - p + k + q \cdot p \cdot \left[ -k - p \cdot k \right]_K \right]_K$$

$$k = \{0,....,K-1\}, j > 0$$

La dispersion d'un algorithme d'entrelacement L(k) correspondant à la distance minimale entre les indices de position des échantillons entrelacés séparés de s-1 échantillons s'exprime sous la forme ΔL (s)= Median|L(k)-L(k+s)|, soit :

$$\Delta L(s) = Min_k \left\{ \left| L(k+s) - L(k) \right|, K - \left| L(k+s) - L(k) \right| \right\}$$

$$\Delta L(s) = Mediane \left\{ \left| L(k+s) - L(k) \right| \right\}$$

Pour l'algorithme TL, la dispersion se calcule algébriquement en considérant la valeur médiane de l'équation (3) lorsque toutes les valeurs de k sont parcourues de 0 à K-1.

$$I_{TL}(k) = I_{p,q}^{(j)}(k) = \left[ K - p + k + q \cdot p \cdot I_{p,q}^{(j-1)}(k) \right]_K \quad k = \{0,....,K-1\}$$

$$L_{TL}(k+s) = I_{p,q}^{(j)}(k+s) = \left[ K - p + k + s + q \cdot p \cdot I_{p,q}^{(j-1)}(k+s) \right]_K$$

$$P_{j,p,q}(k,s) = L_{TL}(k+s) - L_{TL}(k)$$

$$P_{j,p,q}(k,s) = s - \left[ q \cdot p \cdot (s + p \cdot P_{j-1,p,q}(k,s)) \right]_K \quad (j > 1)$$

$$\Delta L_{TL}(s) = \underset{0 \le k \le K-1}{Min} \left\{ \left| P_{j,p,q}(k,s) \right|, K - \left| P_{j,p,q}(k,s) \right| \right\}$$

$$\Delta L_{TL}( s ) = \underset{0 \leq k \leq K-1}{Min} \left\{ \begin{array}{l} \left| s - \left[ q \cdot p( s + p \cdot P_{j-1,p,q}( k,s )) \right]_K \right| \\ , K - \left| s - \left[ q \cdot p \cdot ( s + p \cdot P_{j-1,p,q}( k,s )) \right]_K \right| \end{array} \right\}$$

$$j = 1$$

$$P_{1,p,q}( k,s ) = s - \left[ q \cdot p \cdot s( p + 1 ) \right]_K$$

$$\Delta L_{TL}( s ) = \underset{0 \leq k \leq K-1}{Min} \left\{ \left| \left[ s - q \cdot p \cdot s( 1 + p ) \right]_K \right|, K - \left| \left[ s - q \cdot p \cdot s( 1 + p ) \right]_K \right| \right\}$$

La loi d'entrelacement porte sur un bloc de taille K=$N_{SD}$=736. Elle est optimisée avec le choix des paramètres {p',q',j'}={4,2,2} qui fournissent une dispersion optimale pour de faibles valeurs de s.

La figure 17 représente la dispersion ΔL(s) pour différentes valeurs de s. Les valeurs de s sous multiples de K, vérifiant $[K]_s$ =0, présentant une dispersion ΔL(s) supérieure à la moyenne harmonique MH de la dispersion calculée sur K/2 échantillons sont les valeurs envisageables pour la taille des sous-canaux $N_{SDC}^{(u)}$ elles sont entourées sur la courbe de la figure 17. Sur la figure 17 sont représentées la moyenne harmonique MH (=56) en trait plein ainsi que la valeur médiane ME (=183) en traits pointillés de la dispersion calculée sur K/2 échantillons.

Les simulations au niveau de la couche physique (PHY) montrent que la moyenne harmonique MH est un paramètre plus pertinent pour sélectionner la taille des sous canaux que la valeur médiane ME pour la configuration système considérée. Le procédé est plus précisément illustré en considérant deux valeurs de s qui induisent une faible dispersion (s'=16. 32) et deux valeurs de s qui induisent une dispersion maximale (s'=8, 46).

Si ΔL(s) est inférieur à la moyenne harmonique MH alors on observe des motifs d'entrelacement des symboles sans diversité entre sous canaux, les ressemblances entre motifs entre sous canaux sont importantes, comme illustré par les figures 18 et 12 qui correspondent respectivement à une sélection de s'=16, d'où un nombre de sous canaux $N_{SC}$=46, et à une sélection s'= 32, d'où un nombre de sous canaux $N_{SC}$=23.

Si ΔL(s) est supérieur à la moyenne harmonique MH alors on observe des motifs d'entrelacement des symboles avec diversité entre sous canaux, les différences entre motifs entre sous canaux sont importantes, comme illustré sur les figures 15 et 19 qui correspondent respectivement à une sélection de s'=23, d'où un nombre de canal $N_{SC}$=32, et à une sélection de s'= 46, d'où un nombre de canal $N_{SC}$=16.

Une taille de sous canal $N_{SDC}$ supérieure à MH fournit des performances similaires équivalentes tandis qu'une valeur inférieure à ce seuil MH engendre une dégradation des performances car il engendre une variation des performances en termes de TEB (Taux d'Erreur Binaire). Le tableau 3 en annexe A donne les paramètres de dispersion pour les quatre valeurs de s' précédentes 16, 23, 32 et 46 pour la loi#1.

La pré-sélection de la valeur de s égale à huit conduit à des motifs identiques entre les sous canaux un et trois. Le procédé peut par conséquent évaluer la diversité de motifs d'entrelacement non seulement entre sous canaux adjacents mais en outre entre sous canaux séparés d'un sous canal, voire séparés de plus d'un sous canal pour écarter des valeurs pré-sélectionnées s' qui remplissent un critère d'amplitude pour la dispersion, qui remplissent le critère de diversité géométrique entre sous canaux adjacents mais qui ne remplissent pas le critère de diversité géométrique entre sous canaux séparés d'un sous canal.

Le deuxième exemple se rapporte à un système SYSa pour lequel l'entrelaceur ETS met en oeuvre une loi d'entrelacement RP déduite de l'algorithme de Crozier décrite dans l'article de Crozier S et al : "High-performance low-memory interleaver banks for turbo-codes" IEEE VTC FALL 2001 vol. I of 4 conf. 54 7/10/01 pages 2394-2398, XP010562400, ISBN:0-7803-7005-8.

La loi de Crozier est telle que le paramètre $p_c$ est le paramètre qui fournit la dispersion pour s=1 de la loi d'entrelacement désignée ici par loi d'allocation de porteuse. Le motif de répartition est telle que la dispersion maximale dépend explicitement des valeurs de s.

La loi d'entrelacement $L_{RP}(k)$ est donnée par:

$$L_{RP}( k ) = \left[ s_c + k \cdot p_c \right]_K \qquad k = \{ 0,....,K-1 \}$$

$$\left| L_{RP}(\,k+1\,)-L_{RP}(\,k\,) \right| = p_c$$

L'opération $[X]_K$ correspond à l'opération modulo K appliquée sur X, soit :

$$[X]_K = X - E(\frac{X}{K}) \cdot K$$

La dispersion $\Delta L_{RP}(s)$ est donnée par :

$$L_{RP}(\,k\,) = \left[ s_c + k \cdot p_c \right]_K \qquad k = \{0,....,K-1\}$$

$$\left| L_{RP}(\,k+s\,) - L_{RP}(\,k\,) \right| = \left| \left[ p_c \cdot s \right]_K \right|$$

$$\Delta L_{RP}(\,s\,) = Min\left\{ \left| \left[ p_c \cdot s \right]_K \right|. K - \left| \left[ p_c \cdot s \right]_K \right| \right\}$$

Le tableau 4 en annexe A fournit les valeurs des paramètres de dispersion pour la loi#2:

- La dispersion $\Delta L_{RP}(s)$ pour les valeurs remarquables de s=$N_{SDC}$

- 

  La dispersion moyenne intra sous-canal $\Delta L_{DM}^{int}\,(N_{SDC})$ correspond à la moyenne de la dispersion calculée sur les valeurs de s variant de 0 à $N_{SDC}$-1

- 

  La dispersion moyenne inter-canal $\Delta L_{DM}^{s_c^0}(N_{SDC})$ correspondant à la dispersion entre 4 sous canaux pour un même indice de position entre canaux
- La dispersion à diversité géométrique telle que décrite précédemment.

La dispersion $\Delta L_{RP}(s)$ est représentée sur les figures 20 et 21. La valeur de s=23 est la valeur choisie comme taille de canal fournissant une dispersion adéquate entre sous-canaux.

Un procédé selon l'invention peut être implémenté par différents moyens. Par exemple, le procédé peut être implémenté sous forme câblée (hardware), sous forme logicielle, ou par une combinaison des deux.

Pour une implémentation câblée, le module de mappage pour exécuter les différentes étapes au niveau de l'émetteur peut être intégrés dans un ou plusieurs circuits intégrés spécifiques (ASICs), dans des processeurs de signaux (DSPs, DSPDs), dans des circuits logiques programmables (PLDs, FPGAs), dans des contrôleurs, micro-contrôleurs, microprocesseurs, ou tout autre composant électronique conçu pour exécuter les étapes du procédé préalablement décrit. Il en est de même des différents modules de l'émetteur, en particulier le modulateur, l'entrelaceur fréquentiel et le modulateur multi porteuse.

Pour une implémentation logicielle, quelques unes ou toutes les étapes d'un procédé de mappage peuvent être implémentées par des modules qui exécutent les étapes préalablement décrites. Le code logiciel peut être stocké dans une mémoire et exécuté par un processeur. La mémoire peut faire partie du processeur ou être externe au processeur et couplée à ce dernier par des moyens connus de l'homme de l'art.

En conséquence, l'invention a aussi pour objet un programme d'ordinateur, notamment un programme d'ordinateur sur ou dans un support d'informations ou mémoire, adapté à mettre en oeuvre l'invention. Ce programme peut utiliser n'importe quel langage de programmation, et être sous la forme de code source, code objet, ou de code intermédiaire entre code source et code objet tel que dans une forme partiellement compilée, ou dans n'importe quelle autre forme souhaitable pour implémenter un procédé selon l'invention.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, une EEPROM, une RAM, ou encore un moyen d'enregistrement magnétique, par exemple une disquette (floppy disc) ou un disque dur. Alternativement, le support d'informations peut être un circuit intégré dans lequel le programme est incorporé, le circuit étant adapté pour exécuter ou pour être utilisé dans l'exécution du procédé en question.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Selon une implémentation préférée, les étapes du procédé de mappage sont déterminées par les instructions d'un programme d'émission incorporé dans un circuit électronique telle une puce elle-même pouvant être disposée dans un dispositif électronique tel un émetteur d'une station de base, tel tout équipement d'un réseau sans fil ou telle une station apte à communiquer avec un réseau sans fil via une station de base (tel un terminal mobile). Le procédé de mappage selon l'invention peut tout aussi bien être mis en oeuvre lorsque ce programme est chargé dans un organe de calcul tel un processeur ou équivalent dont le fonctionnement est alors commandé par l'exécution du programme.

Annexe A

Tableau 1

| DL FUSC Wimax | | | | | |
|---|---|---|---|---|---|
| Taille FFT | $N_{SD}$ | Nused | Nsc | $N_{SDC}$ | Permutation DL-Perm_base |
| 2048 | 1536 | | 32 | 48 | 3,18, 2, 8, 16, 10, 11, 15, 26, 22, 6, 9, 27, 20, 25, 1, 29,7, 21. 5, 28, 31, 23, 17, 4, 24, 0, 13, 12, 19, 14, 30 |
| 1024 | 768 | 851 | 16 | 48 | 6, 14, 2, 3, 10, 8, 11, 15, 9, 1, 13, 12, 5, 7, 4, 0 |
| 512 | 384 | 427 | 8 | 48 | 2,0,1,6,4,3,5,7 |
| 128 | 96 | 107 | 2 | 48 | 1,0 |

Tableau 2

| DL PUSC Wimax | | | | | | |
|---|---|---|---|---|---|---|
| Taille FFT | $N_{SD}$ | Nused (avec pilotes+porteuse DC) | Nsc | $N_{SDC}$ | Nclusters | symboles/ cluster |
| 2048 | 1440 | 1681 | 60 | 24 | 120 | 14 |
| 512 | 360 | 421 | 15 | 24 | 30 | 14 |

**Tableau 3**

| s' | Nsc | ΔL(s=s') | $\Delta L_{DM}^{\text{int}}(s')$ | $\Delta L_{DM}^{s_c^o}(s')$ | $\Delta L_{\Delta M}(s')$ |
|---|---|---|---|---|---|
| 46 | 16 | 322 | 187 | 207 | 186 |
| 16 | 46 | 16 | 184 | 40 | 178 |
| 32 | 23 | 32 | 184 | 80 | 181 |
| 23 | 32 | 161 | 177 | 207 | 186 |

**Tableau 4**

| s' | Nsc | ΔL(s=s') | $\Delta L_{DM}^{\text{int}}(s')$ | $\Delta L_{DM}^{s_c^o}(s')$ | $\Delta L_{\Delta M}(s')$ |
|---|---|---|---|---|---|
| 46 | 16 | 46 | 183.5 | 115 | 182.5 |

(suite)

| s' | Nsc | ΔL(s=s') | $\Delta L_{DM}^{int}(s')$ | $\Delta L_{DM}^{S_c^n}(s')$ | $\Delta L_{\Delta M}(s')$ |
|---|---|---|---|---|---|
| 16 | 46 | 16 | 183.5 | 40 | 181.6 |
| 32 | 23 | 32 | 183.5 | 80 | 183 |
| 23 | 32 | 345 | 176.45 | 195.5 | 183.5 |

## Revendications

1. Procédé (1) pour mapper en entrée d'un modulateur multi porteuse des symboles de données entrelacés par bloc de K symboles, dans des sous canaux (SC) de taille égale à $N_{SDC}$ porteuses consécutives répartis sur un ou plusieurs symboles multi porteuses, $N_{SDC}$ étant sous-multiple de K. **caractérisé en ce que** la taille $N_{SDC}$ des sous canaux est déterminée (6) en fonction d'une diversité de motifs d'entrelacement des symboles entre sous canaux.

2. Procédé (1) pour mapper en entrée d'un modulateur multi porteuse selon la revendication 1, dans lequel la diversité de motifs d'entrelacement des symboles entre sous canaux est évaluée pour des groupes de sous canaux distants entre eux d'au plus un sous canal.

3. Procédé (1) pour mapper en entrée d'un modulateur multi porteuse selon la revendication 2, dans lequel les groupes sont composés de paires de sous canaux adjacents.

4. Procédé (1) pour mapper en entrée d'un modulateur multi porteuse selon l'une des revendications précédentes, comprenant :

   - une première étape (7) de calcul d'une fonction de dispersion ΔL(s) représentant la distance minimale entre les symboles d'entrée (X(L(k))) en fonction de l'écart s entre symboles entrelacés (Y(k+s).Y(k)), pour une loi d'entrelacement donnée L(k),
   - une deuxième étape (8) de pré-sélection de valeurs d'écart s', sous multiple de K, pour lesquelles les valeurs de dispersion remplissent un critère d'amplitude,
   - une troisième étape (9) d'évaluation d'une diversité géométrique entre sous canaux pour les différentes valeurs d'écart pré-sélectionnées s', la taille $N_{SDC}$ des sous canaux étant déterminée (10) égale à une des valeurs d'écart pré-sélectionnées s' pour lesquelles la diversité géométrique est maximale.

5. Procédé (1) pour mapper en entrée d'un modulateur multi porteuse selon l'une des revendications précédentes dans lequel K est égale à la taille d'un symbole multi porteuses.

6. Procédé (1) pour mapper en entrée d'un modulateur multi porteuse selon l'une des revendications 1 à 4 dans lequel K est multiple de la taille d'un symbole multi porteuses.

7. Module (MTa) adapté pour mapper en entrée d'un modulateur multi porteuse des symboles de données entrelacés par bloc de K symboles, dans des sous canaux (SC) de taille égale à $N_{SDC}$ porteuses consécutives répartis sur un ou plusieurs symboles multi porteuses, $N_{SDC}$ étant sous-multiple de K,
   **caractérisé en ce que** le module est en outre adapté pour déterminer une taille des sous canaux en fonction d'une diversité de motifs d'entrelacement des symboles entre sous canaux.

8. Emetteur (EMa) d'un signal multi porteuses comprenant, entre un modulateur (CBS) générant des symboles de données et un modulateur (OFDM) multi porteuses générant des symboles multi porteuses, un entrelaceur (ETS) d'un bloc de K symboles de données, adapté en ce qu'il comprend un module (MTa) de mappage selon la revendication 7.

9. Système (SYSa) de transmission d'un signal multi porteuses comprenant un émetteur (EMa) et un récepteur (REa), adapté en ce que l'émetteur est selon la revendication 8.

10. Support d'informations comportant des instructions de programme adaptées à la mise en oeuvre d'un procédé (1) pour mapper en entrée d'un modulateur multi porteuse des symboles de données entrelacés par bloc de K symboles selon l'une quelconque des revendications 1 à 6, lorsque ledit programme est chargé et exécuté dans un dispositif d'émission d'un signal multi porteuses.

11. Un produit programme d'ordinateur chargeable directement dans la mémoire interne d'un dispositif d'émission d'un signal multi porteuses, comprenant des portions de code logiciel pour l'exécution des étapes d'un procédé (1) pour mapper en entrée d'un modulateur multi porteuse des symboles de données entrelacés par bloc de K symboles selon l'une des revendications 1 à 6, lorsque le programme est exécuté par le dispositif d'émission d'un signal multi porteuses.

**Patentansprüche**

1. Verfahren (1) zum Erfassen von Datensymbolen im Eingang eines Mehrträgermodulators, die durch einen Block von K Symbolen verschachtelt sind, in Unterkanälen (SC) der Größe von $N_{SDC}$ aufeinander folgenden Trägern, die auf ein oder mehrere Mehrträgersymbole verteilt sind, wobei $N_{SDC}$ ein Bruchteil von K ist, **dadurch gekennzeichnet, dass** die Größe $N_{SDC}$ dieser Unterkanäle (6) in Abhängigkeit von einer Verschiedenartigkeit von Verschachtelungsmustern der Symbole zwischen Untexkanälen bestimmt ist.

2. Verfahren (1) zum Erfassen im Eingang eines Mehrträgermodulators nach dem Anspruch 1, wobei die Verschiedenartigkeit der Verschachtelungsmuster der Symbole zwischen den Unterkanälen für Gruppen von Unterkanälen bewertet wird, die höchstens einen Unterkanal voneinander entfernt sind.

3. Verfahren (1) zum Erfassen im Eingang eines Mehrträgermodulators nach dem Anspruch 2, wobei die Gruppen aus benachbarten Paaren von Unterkanälen bestehen.

4. Verfahren (1) zum Erfassen im Eingang eines Mehrträgermodulators nach einem der vorhergehenden Ansprüche, umfassend:

   - einen ersten Schritt (7) des Berechnens einer Dispersionsfunktion $\Delta L$ (s), die den Mindestabstand zwischen den Eingangssymbolen(X(L(k))) in Abhängigkeit der Abweichung s zwischen verschachtelten Symbolen (Y (k+s),Y(k)) für ein bestimmtes Verschachtelungsgesetz L(k) darstellt,
   - einen zweiten Schritt (8) des Vorauswählens der Abweichungswerte s', ein Bruchteil von K, für die die Dispersionswerte ein Amplitudenkriterium erfüllen,
   - einen dritten Schritt (9) des Bewertens einer geometrischen Verschiedenartigkeit zwischen Unterkanälen für die verschiedenen vorgewählten Abweichungswerte s', wobei die Größe $N_{SDC}$ der Unterkanäle (10) gleich einem der vorgewählten Abweichungswerte s' bestimmt wird, für die die geometrische Verschiedenartigkeit maximal ist.

5. Verfahren (1) zum Erfassen im Eingang eines Mehrträgermodulators nach einem der vorhergehenden Ansprüche, bei dem K gleich der Größe eines Mehrträgersymbols ist.

6. Verfahren (1) zum Erfassen im Eingang eines Mehrträgermodulators nach einem der Ansprüche 1 bis 4, bei dem K ein Mehrfaches der Größe eines Mehrträgersymbols ist.

7. Modul (MTa), das zum Erfassen von Datensymbolen im Eingang eines Mehrträgermodulators geeignet ist, die durch einen Block von K Symbolen verschachtelt sind, in Unterkanälen (SC) der Größe von $N_{SDC}$ aufeinander folgenden Trägern, die auf ein oder mehrere Mehrträgersymbole verteilt sind, wobei $N_{SDC}$ ein Bruchteil von K ist, **dadurch gekennzeichnet, dass** das Modul ebenfalls geeignet ist, um eine Größe der Unterkanäle in Abhängigkeit von einer Verschiedenartigkeit von Verschachtelungsmustern der Symbole zwischen Unterkanälen zu bestimmen.

8. Sender (EMa) eines Mehrträgersignals, der zwischen einem Modulator (CBS), der Datensymbole generiert, und einem Mehrträgermodulator (OFDM), der Mehrträgersymbole generiert, einen Interleaver (ETS) eines Blocks K von Datensymbolen aufweist, der dazu eingerichtet ist, dass er ein Erfassungsmodul (MTa) nach dem Anspruch 7 aufweist.

9. Übertragungssystem (SYSa) eines Mehrträgersignals, das einen Sender (EMa) und einen Empfänger (REa) aufweist, das dazu eingerichtet ist, dass der Sender nach dem Anspruch 8 ist.

10. Informationsträger, der Programmanweisungen aufweist, die dazu eingerichtet sind, um ein Verfahren (1) zu erstellen, um im Eingang eines Mehrträgermodulators Datensymbole, die durch den Block K von Symbolen verschachtelt sind, nach einem der Ansprüche 1 bis 6 zu erfassen, wenn das Programm in einer Vorrichtung zum Senden eines Mehrträgersignals eingegeben ist und ausgeführt wird.

11. Ein Computerprogrammprodukt, das direkt in den internen Speicher einer Vorrichtung zum Senden eines Mehrträgersignals eingegeben werden kann, das Software-Codeteile zum Durchführen der Schritte eines Verfahrens (1) zum Erfassen von Datensymbolen im Eingang eines Mehrträgermodulators aufweist, die durch einen Block K von Symbolen verschachtelt sind, nach einem der Ansprüche 1 bis 6, wenn das Programm von der Vorrichtung zum Senden eines Mehrträgersignals ausgeführt wird.

**Claims**

1. Method (1) for mapping at the input of a multi-carrier modulator data symbols interleaved by block of K symbols in sub-channels (SC) of a size equal to $N_{SDC}$ consecutive carriers distributed over one or more multi-carrier symbols, $N_{SDC}$ being a sub-multiple of K, **characterized in that** the size $N_{SDC}$ of the sub-channels is determined (6) as a function of a symbol interleaving pattern diversity between sub-channels.

2. Method (1) for mapping at the input of a multi-carrier modulator according to Claim 1, in which the symbol interleaving pattern diversity between sub-channels is evaluated for groups of sub-channels mutually separated by one sub-channel at the most.

3. Method (1) for mapping at the input of a multi-carrier modulator according to Claim 2, in which the groups are composed of pairs of adjacent sub-channels.

4. Method (1) for mapping at the input of a multi-carrier modulator according to one of the preceding claims, comprising:

    - a first step (7) of calculating a dispersion function $\Delta L(s)$ representing the minimum distance between the input symbols $(X(L(k)))$ as a function of the separation s between interleaved symbols $(Y(k+s), Y(k))$, for a given interleaving relationship $L(k)$,
    - a second step (8) of pre-selecting values of separation s', a sub-multiple of K, for which the dispersion values meet an amplitude criterion,
    - a third step (9) of devaluating a geometric diversity between sub-channels for the various pre-selected values of separation s', the size $N_{SDC}$ of the sub-channels being determined (10) equal to one of the pre-selected separation values s' for which the geometrical diversity is maximale.

5. Method (1) for mapping at the input of a multi-carrier modulator according to one of the preceding claims, in which K is equal to the size of a multi-carrier symbol.

6. Method (1) for mapping at the input of a multi-carrier modulator according to Claims 1 to 4, in which K is a multiple of the size of a multi-carrier symbol.

7. Module (MTa) adapted for mapping at the input of a multi-carrier modulator data symbols interleaved by block of K symbols in sub-channels (SC) of a size equal to $N_{SDC}$ consecutive carriers distributed over one or more multi-carrier symbols, $N_{SDC}$ being a sub-multiple of K,
**characterized in that** the module is furthermore adapted to determine a sub-channel size as a function of a symbol interleaving pattern diversity between sub-channels.

8. Transmitter (EMa) of a multi-carrier signal comprising, between a modulator (CBS) generating data symbols and a multi-carrier modulator (OFDM) generating multi-carrier symbols, an interleaver (ETS) of a block of K data symbols, adapted in that it comprises a mapping module (MTa) according to Claim 7.

9. System (SYSa) for transmitting a multi-carrier signal comprising a transmitter (EMa) and a receiver (REa), adapted in that the transmitter is according to Claim 8.

10. Information medium containing program instructions suitable for the implementation of a method (1) for mapping at the input of a multi-carrier modulator data symbols interleaved by block of K symbols according to any one of Claims 1 to 6, when said program is loaded and executed in a device for transmitting a multi-carrier signal.

11. A computer program product that can be directly loaded into the internal memory of a device for transmitting a multi-carrier signal, comprising portions of software code for the execution of the steps of a method (1) for mapping at the input of a multi-carrier modulator data symbols interleaved by block of K symbols according to one of Claims 1 to 6, when the program is executed by the device for transmitting a multi-carrier signal.

**Fig. 1**

**Fig. 2**

**Fig. 3**

**Fig. 4**

Fig. 5

Fig. 6

Fig. 7

**Fig. 8**

Fig. 9

Fig. 10

Fig. 10a

Fig. 10b

Fig. 10

**Fig. 11a**

**Fig. 11b**

**Fig. 11**

**Fig. 12**

Fig. 14

**Fig. 13**

$K=N_{SD}=736$, $N_{SDC}^{(u)}=23$, $N_{SC}=32$, $\{p',q',j'\}=\{4,2,2\}$

**Fig. 15**

SC#0  —△— SC#1  - -*- - SC#2

**Fig. 16**

**L(k) #1**

**Fig. 17**

$K=N_{SD}=736$, $N_{SDC}=16$, $N_{SC}=46$, $\{p',q',j'\}=\{4,2,2\}$

**Fig. 18**

**Fig. 19**

K=N$_{SD}$=736, N$_{SDC}$=46, N$_{SC}$=16, {p',q',j'}={4,2,2}

- - ◆ - SC#0    —△— SC#1    - ● - SC#2

L(k )#2

**Fig. 20**

L(k )#2

**Fig. 21**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2005265469 A1
- WO 2006072694 A
- WO 2006072694 W

### Littérature non-brevet citée dans la description

- **CROZIER S et al.** High-performance low-memory interleaver banks for turbo-codes. *IEEE VTC FALL,* 10 Juillet 2001, vol. I-4, ISBN 0-7803-7005-8, 2394-2398